# EUROPEAN PATENT APPLICATION

(11) **EP 4 601 434 A1**
(43) Date of publication of application: **13.08.2025**
(21) Application number: 25150201.9
(22) Date of filing: 03.01.2025
(51) Int. Cl.: H10F 10/142, H10F 10/144, H10F 19/75

(54) **MULTI-JUNCTION PHOTOVOLTAIC SOLAR CELL WITH AN INTEGRATED, MONOLITHIC BLOCKING DIODE**

(30) Priority: 07.02.2024 US 202418435379
(71) Applicant: The Boeing Company, Arlington, VA 22202 (US)
(72) Inventor: Rehder, Eric, Arlington, 22202 (US)
(74) Representative: Witte, Weller & Partner Patentanwälte mbB

(57) **Abstract**

A multi-junction, photovoltaic (PV) solar cell with an integrated, monolithic blocking diode, and methods of fabrication, are disclosed. The integrated, monolithic blocking diode protects a circuit of PV solar cells when some PV solar cells are shadowed. A triple-junction PV solar cell includes a first conductive substrate with a PV solar cell stack and an adjacent blocking diode stack disposed on a common conductive substrate. A trench is located in between the two stacks, which provides electrical isolation. A triple-junction cell has: a Ge first PN junction, a GaAs second PN junction, and an InGaP third PN junction. A first metal contact is disposed on a portion of the PV solar cell stack, and a second metal contact is disposed completely across the blocking diode stack. Extraterrestrial satellites can use these triple-junction PV solar cells with integrated, monolithic blocking diodes.

## Description

This disclosure relates to multi-junction, photovoltaic (PV) solar cells with integrated, monolithic blocking diodes. In particular, the disclosure relates to triple-junction PV solar cells for use with satellites and spacecraft.

### BACKGROUND

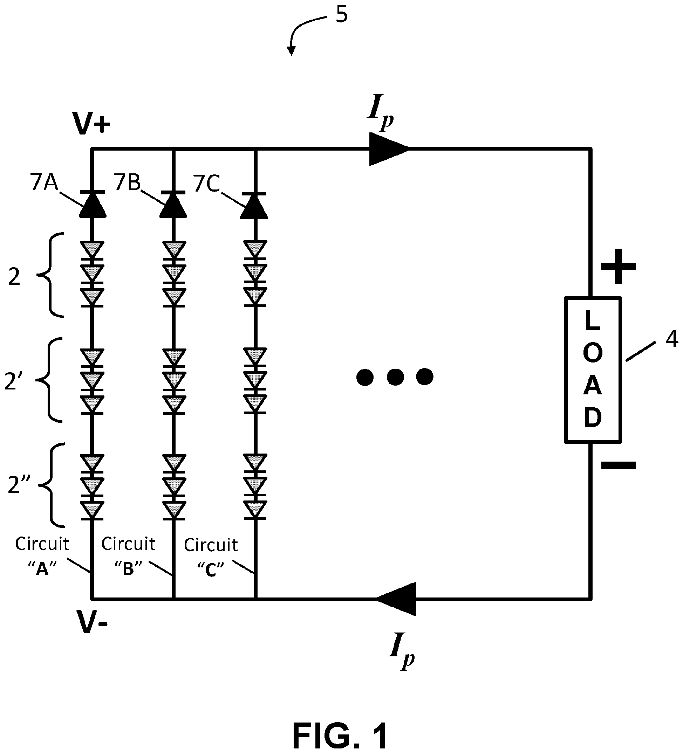

FIG. 1 shows a schematic electrical diagram of three PV solar cell circuits (A, B, and C) connected to a Load 4. Each individual circuit A, B, or C comprises three PV solar cells 2, 2', and 2" connected in series. The three circuits (Circuit "A", Circuit "B", and Circuit "C") are connected in parallel. When all PV solar cells are illuminated, a forward voltage bias is generated across each cell. Panel current ***Iₚ*** is driven by the voltage difference = (**V**₊ - **V**₋). PV solar panel 5 is connected to load 4, which can be a battery, motor, lights, computers, etc. However, if one or more of the PV solar cells 2, 2', or 2" are shadowed, then the shadowed cell(s) will become reverse biased and act as a diode. To mitigate this situation, a series of discrete, external blocking diodes 7A, 7B, and 7C are serially attached to the positive end of each Circuit A, B, and C, respectively. These discrete blocking diodes 3A, 3B, 3C serve to protect their respective circuit of three PV solar cells when one or more PV solar cells are shadowed and stop producing energy. Without the use of these discrete, external blocking diodes, a short in one circuit would short the power in all of the circuits, thereby greatly reducing the total power delivered to the load 4. Hence, the discrete, external blocking diodes block current from reaching defects in other circuits.

### SUMMARY

A multi-junction, photovoltaic (PV) solar cell with an integrated, monolithic blocking diode, and methods of fabrication, are disclosed. The integrated, monolithic blocking diode protects a circuit of PV solar cells when one or more PV solar cells are shadowed. A triple-junction PV solar cell can include a first conductive substrate with a p-doped second layer disposed above the substrate, with a PV solar cell stack and an adjacent blocking diode stack disposed on the second layer. A trench is located in between the two stacks, which provides electrical isolation. The triplejunction cell can have (1) a Ge first PN junction, (2) a GaAs second PN junction, and (3) an InGaP third PN junction, among other layers. A first metal contact is disposed on a portion of the PV solar cell stack, and a second metal contact is disposed completely across the blocking diode stack. Many PV solar cells can be electrically connected in series as a single string. The integrated, monolithic blocking diodes protect the string when one or more solar cells are shadowed. If one solar cell is shadowed, then the illuminated solar cell applies a reverse voltage on the shadowed cell and can damage it. Extraterrestrial satellites can use these triple-junction PV solar cells with integrated, monolithic blocking diodes.

In one example (Type A), a multi-junction, photovoltaic (PV) solar cell with an integrated, monolithic blocking diode includes: (1) a conductive first layer, having a width = D, that is made of a conductive metal; (2) a p-doped second layer, having a width = D, that is disposed above the first layer and is made of a p-doped first semiconductor material; (3) a PV solar cell stack, having a width = A, that is disposed above the p-doped second layer; (4) a blocking diode stack, having a width = C, that is disposed above the p-doped second layer; (5) a first vertical trench, having a width = B, that extends down into the p-doped second layer, and is located in between the PV solar cell stack and the blocking diode stack; (6) a first metal contact, having a width = E, that is disposed on a portion of the PV solar cell stack; and (7) a second metal contact, having a width = C, that is disposed completely across a top surface of the blocking diode stack. The PV solar cell stack has an active solar width with a width = F. The PV solar cell stack and the blocking diode are both disposed above the second layer. The various dimensions follow these rules: E < A, E < F, F < A, B < C, B < A, A < D, C < D, A = E + F, and D = A + B + C.

In some examples, the PV solar cell further includes an n-doped third layer, having a width = A, made of an n-doped first semiconductor material that is disposed above the p-doped second layer (thereby forming a first PN junction in both the PV solar cell stack and the blocking diode stack). The first semiconductor material can be germanium (Ge).

In some examples, the PV solar cell stack can have the same number of layers as the blocking diode stack. Alternatively, the PV solar cell stack can have fewer layers than the blocking diode stack. Alternatively, the PV solar cell stack can have more layers than the blocking diode stack. The second metal contact can be disposed directly above the p-doped second layer, thereby forming a p-type Schottky diode. In some examples, the second metal contact is disposed directly above the n-doped third layer, thereby forming an n-type Schottky diode.

The PV solar cell can further comprise a p-doped fourth layer, having a width = A, that is disposed above the n-doped third layer. The p-doped fourth layer is made of a p-doped second semiconductor material. The PV solar cell can additionally include an n-doped fifth layer, having a width = A, that is disposed above the p-doped fourth layer. The n-doped fifth layer is made of a n-doped second semiconductor material. In some examples, the second semiconductor material can be gallium arsenide (GaAs).

The PV solar cell can additionally include a p-doped sixth layer, having a width = A, that is disposed above the n-doped fifth layer. The p-doped sixth layer is made of a p-doped third semiconductor material. The PV solar cell can additionally include an n-doped seventh layer, having a width = A, that is disposed above the p-doped sixth layer. The n-doped seventh layer is made of an n-doped third semiconductor material. The third semiconductor material can be indium-gallium-phosphorus (InGaP). This makes a triple-junction PV solar cell. In some examples, the p-doped second semiconductor material is located in between the second metal contact and the n-doped third layer, thereby forming a p-type Schottky diode. The PV solar cell can include a first electrical conductor connecting the first metal contact to a negative side of a load, and a second electrical conductor connecting the second metal contact to a positive side of the load.

In another example (Type B), a triple-junction, photovoltaic (PV) solar cell with an integrated, monolithic blocking diode includes: (1) a conductive first layer, having a width = F, which is made of a conductive metal; (2) a p-doped second layer, having a width = F, which is made of a p-doped first semiconductor material that is disposed above the first layer; (3) an n-doped third layer, having a width = A, which is made of an n-doped first semiconductor material that is disposed above the second layer; (4) a p-doped fourth layer, having a width = A, which is made of a p-doped second semiconductor material that is disposed above the n-doped third layer; (5) an n-doped fifth layer, having a width = A, which is made of an n-doped second semiconductor material that is disposed above the p-doped fourth layer; (6) a p-doped sixth layer, having a width = A, which is made of a p-doped third semiconductor material that is disposed above the n-doped fifth layer; (7) an n-doped seventh layer, having a width = A, which is made of an n-doped third semiconductor material that is disposed above the p-doped sixth layer; (8) an n-doped eighth layer, having a width = I, which is made of an n-doped second semiconductor material that is disposed above the n-doped seventh layer; and (9) a p-doped ninth layer, having a width = I, which is made of an p-doped second semiconductor material that is disposed on a portion of the n-doped eighth layer. The PV solar cell stack, having a width= A, is disposed above the second layer, and the blocking diode stack, having a width = C, is also disposed above the second layer. A first vertical trench, having a width = B, extends down into the p-doped second layer and is disposed in between the PV solar cell stack and the blocking diode stack. A first metal contact, having a width = G, is disposed on a portion of a top surface of the PV solar cell stack. A second metal contact, having a width = E, is disposed above the third layer. A third metal contact, having a width = I, is disposed above the p-doped ninth layer; and a fourth metal contact, having a width = K, is disposed above the n-doped eighth layer.

Furthermore, regarding the Type B example, a second vertical trench, having a width = J, extends down into the n-doped eighth layer, and is disposed in between the n-doped eighth layer and the fourth metal contact. A third vertical trench, having a width = D, extends down into the n-doped third layer, and is disposed in between the blocking diode stack and the second metal contact. A conductive metal shunt, which can be a wire, ribbon, or an integrated, monolithic connection, electrically connects the third metal contact to the fourth metal contact. The PV solar cell stack has an active solar width with a width = H. The PV solar cell stack and the blocking diode are both disposed above the second layer. The dimensions of this triple-junction assembly follow these rules: A < F, C < D, B < A, B < C, G < A, I < C, K < C, J < C, G < H, H < A, A = G + H, C = I + J + K, and F = A + B + C + D + E.

In another example, the PV solar cell can additionally include an intermediate layer of n-doped first semiconductor material that is inserted in between the second layer the second metal contact. In some examples, every PV solar cell can have their own integrated, monolithic blocking diode. In another example, an extraterrestrial satellite can have a PV solar panel attached to the satellite, wherein the PV solar panel comprises one or more triple-junction, PV solar cells with integrated, monolithic blocking diodes, as previously described. For the satellite application, the first semiconductor material can be Ge; the second semiconductor material can be GaAs; and the third semiconductor material can be InGaP.

In another example, a string of three, identical, individual PV solar cells are electrically connected in series to make a PV assembly, using either the Type A or Type B PV solar cell structure previously described. Each PV solar cell has its own blocking diode, but only the third PV solar cell is electrically connected to a load. A first electrical conductor is connected to the first layer of the first PV solar cell at one end and to the upper metal contact on top of the PV solar cell stack on the second PV solar cell at the other end (i.e., a series connection). Additionally, a second conductor is connected to the first layer of the second PV solar cell at one end and to the upper metal contact on top of the PV solar cell stack on the third PV solar cell at the other end. This links the three PV solar cells in series. A third conductor connects the upper metal contact on the first PV solar cell to a negative side of a load, and a fourth conductor connects the upper metal contact on the third PV solar cell to a positive side of the load, to complete the circuit.

In some examples, the PV solar cell can be a dual-junction or a triple junction solar cell. Single junction solar cells, in general, don't generate a sufficiently high voltage to "turn-on" the integrated, monolithic blocking diodes,

### BRIEF DESCRIPTION OF THE DRAWINGS

FIG. 1 shows a schematic electrical diagram of three PV solar cell circuits connected to a load.
FIG. 2A shows a plan view of a schematic example of an electrical circuit comprising a series of three, illuminated, triple-junction PV solar cells (connected in series), with each cell having their own individual bypass diode, all connected in series to a load, according to the present disclosure.
FIG. 2B shows a plan view of a schematic example of the electrical circuit shown in FIG. 2A, wherein the middle triple junction PV solar cell is *shadowed,* according to the present disclosure.
FIG. 3A shows a schematic elevation cross-section view of an example of a PV assembly comprising a generic multi-junction, photovoltaic solar cell with an integrated, monolithic blocking diode, wherein the number of layers in the PV solar cell is *the same* as the number of layers in the blocking diode, according to the present disclosure.
FIG. 3B shows a schematic elevation cross-section view of an example of a PV assembly comprising a generic multi-junction, photovoltaic solar cell with an integrated, monolithic blocking diode, wherein the number of layers in the PV solar cell is *different* (i.e., fewer) than the number of layers in the blocking diode, according to the present disclosure.
FIG. 4A shows a schematic elevation cross-section view of an example of a dual-junction, photovoltaic solar cell with an integrated, monolithic blocking diode, according to the present disclosure.
FIG. 4B shows a schematic elevation cross-section view of an example of a multi-junction, photovoltaic solar cell with an integrated, monolithic blocking diode, with specific material selections, according to the present disclosure.
FIG. 4C shows a schematic elevation cross-section view of an example of a multi-junction, photovoltaic solar cell with an integrated, monolithic blocking diode electrically connected to a Load, with specific material selections, according to the present disclosure.
FIG. 5A shows a schematic elevation cross-section view of an example of a multi-junction, photovoltaic solar cell with an integrated, monolithic blocking diode, according to the present disclosure.
FIG. 5B shows a schematic elevation cross-section view of an example of a multi-junction, photovoltaic solar cell with an integrated, monolithic blocking diode, with specific material selections, according to the present disclosure.
FIG. 5C shows a schematic elevation cross-section view of an example of a multi-junction, photovoltaic solar cell with an integrated, monolithic blocking diode electrically connected to a Load, with specific material selections, according to the present disclosure.
FIG. 6A shows a schematic elevation cross-section view of an example of a multi-junction, photovoltaic solar cell with an integrated, monolithic blocking diode, according to the present disclosure.
FIG. 6B shows a schematic elevation cross-section view of an example of a multi-junction, photovoltaic solar cell with an integrated, monolithic blocking diode, with specific material selections, according to the present disclosure.
FIG. 6C shows a schematic elevation cross-section view of an example of a multi-junction, photovoltaic solar cell with an integrated, monolithic blocking diode electrically connected to a Load, with specific material selections, according to the present disclosure.
FIG. 7A shows a schematic elevation cross-section view of an example of a multi-junction, photovoltaic solar cell with an integrated, monolithic blocking diode, according to the present disclosure.
FIG. 7B shows a schematic elevation cross-section view of an example of a multi-junction, photovoltaic solar cell with an integrated, monolithic blocking diode, with specific material selections, according to the present disclosure.
FIG. 7C shows a schematic elevation cross-section view of an example of a multi-junction, photovoltaic solar cell with an integrated, monolithic blocking diode electrically connected to a Load, with specific material selections, according to the present disclosure.
FIG. 8A shows a schematic elevation cross-section view of an example of a multi-junction, photovoltaic solar cell with an integrated, monolithic blocking diode, according to the present disclosure.
FIG. 8B shows a schematic elevation cross-section view of an example of a multi-junction, photovoltaic solar cell with an integrated, monolithic blocking diode, with specific material selections, according to the present disclosure.
FIG. 8C shows a schematic elevation cross-section view of an example of a multi-junction, photovoltaic solar cell with an integrated, monolithic blocking diode electrically connected to a Load, with specific material selections, according to the present disclosure.
FIG. 9A shows a schematic elevation cross-section view of an example of a multi-junction, photovoltaic solar cell with an integrated, monolithic blocking diode, according to the present disclosure.
FIG. 9B shows a schematic elevation cross-section view of an example of a multi-junction, photovoltaic solar cell with an integrated, monolithic blocking diode, with specific material selections, according to the present disclosure.
FIG. 9C shows a schematic elevation cross-section view of an example of a multi-junction, photovoltaic solar cell with an integrated, monolithic blocking diode electrically connected to a Load, with specific material selections, according to the present disclosure.
FIG. 9D shows a schematic elevation cross-section view of an example of a multi-junction, photovoltaic solar cell with an integrated, monolithic blocking diode and an integrated, monolithic shunt, according to the present disclosure.
FIG. 10A shows a schematic elevation cross-section view of an example of a multi-junction, photovoltaic solar cell with an integrated, monolithic blocking diode, according to the present disclosure.
FIG. 10B shows a schematic elevation cross-section view of an example of a multi-junction, photovoltaic solar cell with an integrated, monolithic blocking diode, with specific material selections, according to the present disclosure.
FIG. 10C shows a schematic elevation cross-section view of an example of a multi-junction, photovoltaic solar cell with an integrated, monolithic blocking diode electrically connected to a Load, with specific material selections, according to the present disclosure.
FIG. 11A shows a schematic elevation cross-section view of an example of a multi-junction, photovoltaic solar cell with an integrated, monolithic blocking diode, according to the present disclosure.
FIG. 11B shows a schematic elevation cross-section view of an example of a multi-junction, photovoltaic solar cell with an integrated, monolithic blocking diode, with specific material selections, according to the present disclosure.
FIG. 11C shows a schematic elevation cross-section view of an example of a multi-junction, photovoltaic solar cell with an integrated, monolithic blocking diode electrically connected to a Load, with specific material selections, according to the present disclosure.
FIG. 12A shows a schematic elevation cross-section view of an example of a multi-junction, photovoltaic solar cell with an integrated, monolithic blocking diode, according to the present disclosure.
FIG. 12B shows a schematic elevation cross-section view of an example of a multi-junction, photovoltaic solar cell with an integrated, monolithic blocking diode, with specific material selections, according to the present disclosure.
FIG. 12C shows a schematic elevation cross-section view of an example of a multi-junction, photovoltaic solar cell with an integrated, monolithic blocking diode electrically connected to a Load, with specific material selections, according to the present disclosure.
FIG. 13A shows a schematic elevation cross-section view of an example of a multi-junction, photovoltaic solar cell with an integrated, monolithic blocking diode, according to the present disclosure.
FIG. 13B shows a schematic elevation cross-section view of an example of a multi-junction, photovoltaic solar cell with an integrated, monolithic blocking diode, with specific material selections, according to the present disclosure.
FIG. 13C shows a schematic elevation cross-section view of an example of a multi-junction, photovoltaic solar cell with an integrated, monolithic blocking diode electrically connected to a Load, with specific material selections, according to the present disclosure.
FIG. 14A shows a schematic cross-section view of an example of an electrical circuit comprising an PV assembly comprising a plurality of PV solar cells connected in series to a Load 4, with a single, integrated, monolithic blocking diode that is integrated with PV solar cell, according to the present disclosure.
FIG. 14B shows a schematic cross-section view of an example of an electrical circuit comprising a plurality of PV solar cells, connected in series to a Load, wherein each PV solar cell comprises their own individual, integrated, monolithic blocking diode, according to the present disclosure.
FIG. 15 shows a schematic cross-section view of an example of an electrical circuit comprising a PV assembly comprising a plurality of PV solar cells, connected in series to a Load, with a single, integrated, monolithic blocking diode, according to the present disclosure.
FIG. 16A shows a schematic elevation cross-section view of an example of a first step of fabricating a multi-junction, photovoltaic solar cell with an integrated, monolithic blocking diode, according to the present disclosure.
FIG. 16B shows a schematic elevation cross-section view of an example of a second step of fabricating a multi-junction, photovoltaic solar cell with an integrated, monolithic blocking diode, according to the present disclosure.
FIG. 16C shows a schematic elevation cross-section view of an example of a third step of fabricating a multi-junction, photovoltaic solar cell with an integrated, monolithic blocking diode, according to the present disclosure.
FIG. 16D shows a schematic elevation cross-section view of an example of a fourth step of fabricating a multi-junction, photovoltaic solar cell with an integrated, monolithic blocking diode, according to the present disclosure.
FIG. 16E shows a schematic elevation cross-section view of an example of a fifth step of fabricating a multi-junction, photovoltaic solar cell with an integrated, monolithic blocking diode, according to the present disclosure.
FIG. 16F shows a schematic elevation cross-section view of an example of a sixth step of fabricating a multi-junction, photovoltaic solar cell with an integrated, monolithic blocking diode, according to the present disclosure.
FIG. 17 shows a process flow chart illustrating an example of process steps for fabricating a PV solar cell with an integrated, monolithic blocking diode by using semiconductor processes, according to the present disclosure.
FIG. 18 shows a schematic perspective view of an example of an extraterrestrial satellite with a pair of PV solar panels that are attached to the satellite, wherein each PV solar panel comprises a triple-junction, PV solar cell with an integrated, monolithic blocking diode, according to the present disclosure.

### DETAILED DESCRIPTION OF THE DISCLOSURE

The phrase "PN junction" broadly includes both "p-on-n" and "n-on-p" junctions. The word "metal" includes "metal alloys". The phrase "active solar width" means an exposed portion of the PV solar cell stack that is capable of absorbing sunlight and actively converting that sunlight into a photocurrent. The word "sunlight" is broadly defined as including all sources of photons (i.e.,"light"). The phrase "PV solar cell" means that the PV solar cell comprises one or more pairs of differently-doped p- or n-semiconductor layers, wherein each pair has a unique PN junction at the interface between the two differently-doped semiconductor layers. The words "conductor" and "connector" are used interchangeably herein. The words "stack" and "mesa" are used interchangeably herein. The word "integrated" means a unified construction, in general, and it refers to integrated semiconductor constructs in particular. The word "monolithic" means "consisting of one piece" in general, and it relates to forming an integrated electronic circuit on a single chip, in particular.

The number of stacked solar cells in a single PV solar cell can range from one solar cell to as many as six stacked solar cells in a single, high-efficiency PV solar cell. The solar cell stacks comprise a series of PN diodes joined by PN tunnel diodes. The individual tunnel junctions are not illustrated in the following figures, but they are present in every example. The schematic figures illustrated herein do not show many other layers that can be added to a specific design. In general, the voltage generated by the PV solar cell must be greater than the turn-on voltage of the blocking diode.

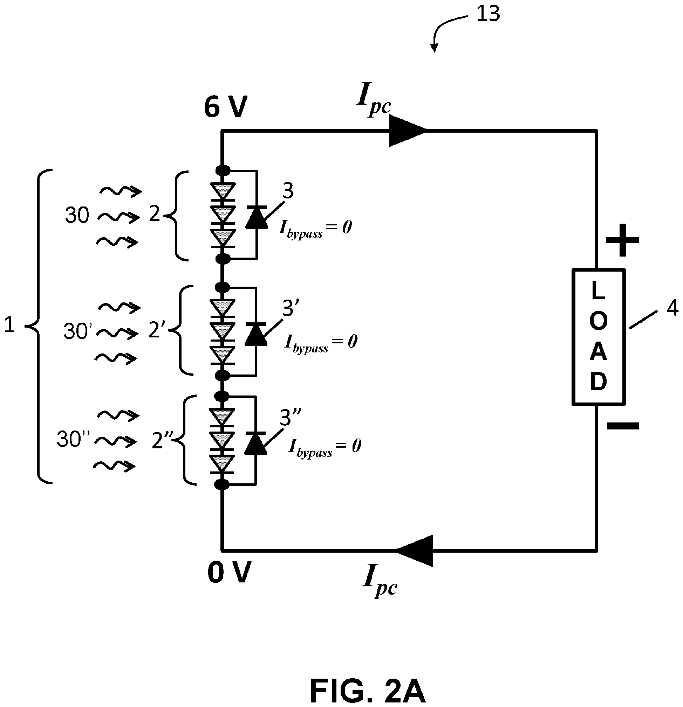

FIG. 2A shows a plan view of a schematic example of an electrical circuit 13 comprising a series 1 of three, illuminated, triple-junction PV solar cells 2, 2', 2" (connected in series), with each cell having their own individual bypass diode 3, 3', 3", respectively, all connected in series to a load 4, according to the present disclosure. Each PV solar cell 2, 2', 2" is a triple-junction cell that comprises three serial PN junctions stacked on top of each other (these are illustrated as three, internal diodes connected in series). Normally, when illuminated with sunlight 30, the circuit's loop photocurrent, ***I_{pc}**,* flows through, for example, PV solar cell 2 and not through parallel bypass diode 3 (which is normally blocked, i.e., *I_{blocking} =* 0). Note that no discrete, external blocking diodes are used in circuit 13 (see FIG. 1).

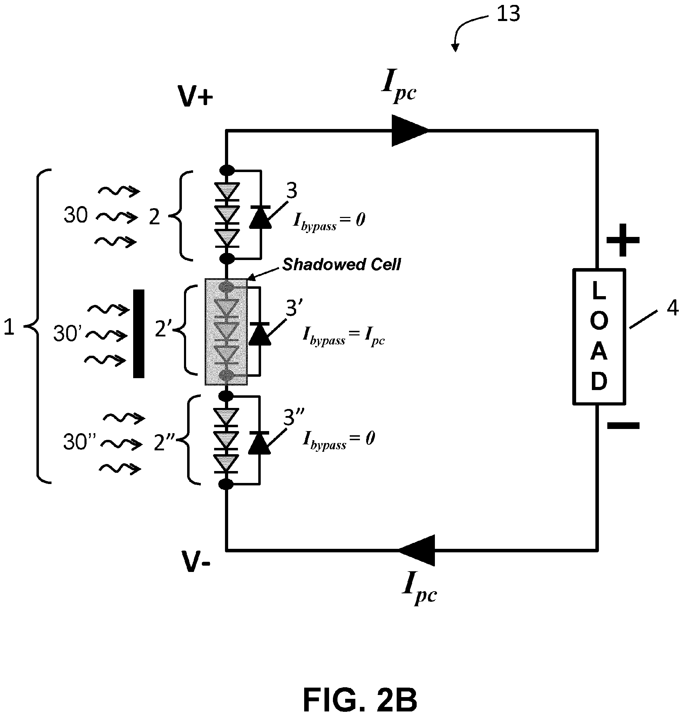

FIG. 2B shows a plan view of a schematic example of the electrical circuit 13 shown in FIG. 2A, wherein the middle triple junction PV solar cell 2' is *shadowed,* according to the present disclosure. When solar cell 2' is shadowed, the voltage from the rest of circuit 13 is reverse biased against the shadowed PV solar cell 2' and its associated, parallel bypass diode 3'. The current ***I_{pc}*** then flows through bypass diode 3'. The circuit voltage is then the voltage from the series of operating (active) solar cells (e.g., 2 solar cells), minus the voltage to turn on the bypass diode 3'.

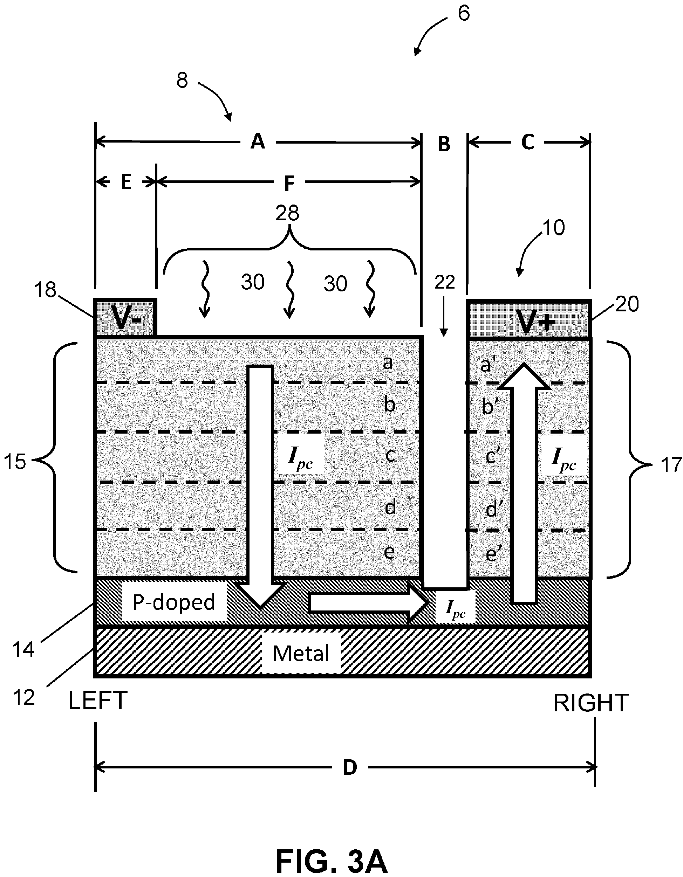

FIG. 3A shows a schematic elevation cross-section view of an example of a PV assembly 6 comprising a generic, multi-junction, PV solar cell 8 with an integrated, monolithic blocking diode 10, wherein the number of layers in the PV solar cell 8 is the same as the number of layers in the blocking diode 10, according to the present disclosure. First layer 12, having a width = D, comprises a conductive metal or metal alloy. Second layer 14, having a width = D, which can comprise a p-doped first semiconductor material, is disposed on first layer 12. PV solar cell stack 15, having a width = A, is disposed on a left-side portion of second layer 14 and comprises generic multi-junction semiconductor layers, for example, a, b, c, d, and e. PV solar cell stack 15 comprises at least one PN junction (not identified). First metal contact 18, having a width = E, is disposed on top of a portion of PV solar cell stack 15. Incident light 30 (e.g., sunlight) illuminates active area 28 (having a width = F) of PV solar cell stack 15.

In some examples, the semiconductor materials used herein can be selected from doped silicon, doped germanium (Ge), doped gallium arsenide (GaAs), or doped indium-gallium-phosphide (InGaP), or combinations thereof. The p-dopant element can be selected from boron, gallium, aluminum, or indium, or combinations thereof. The n-dopant element can be selected from phosphorus, arsenic, antimony, bismuth, or lithium, or combinations thereof. Conductive metal contacts 18 and 20 can be selected from Cu, Au, Ag, Al, Ti, or W, or combinations thereof. Referring still to FIG. 3A, blocking diode 10 can have a blocking diode stack 17, having a width = C, which is disposed on a right-side portion of second layer 14 and comprises generic semiconductor layers a', b', c', d', and e', plus second layer 14. First vertical trench 22, having a width = B, extends into a top surface of second layer 14, and is disposed in between PV solar cell stack 15 and blocking diode stack 17. Second metal contact 20, having a width = C, is disposed completely across a top of blocking diode stack 17 (which prevents sunlight 30 from reaching the blocking diode semiconductor stack 17). Photocurrent ***I_{pc}*** flows top-to-bottom from first metal contact 18 (at voltage = **V-)** through PV solar cell 8 and down through second layer 14. Then, photocurrent ***I_{pc}*** flows horizontally across conductive p-doped second layer 14. Finally, photocurrent ***I_{pc}*** flows (from bottom-to-top) through blocking diode stack 17 to second metal contact 20 (at voltage = **V+).** PV solar cell stack 15 comprises, for example, five generic semiconductor layers (a, b, c, d, and e) plus second layer 14. Blocking diode stack 17 also comprises, for example, the same five semiconductor layers (a', b', c', d', and e') plus second layer 14, as is used in the adjacent PV solar cell stack 15. PV solar cell stack 15 and blocking diode stack 17 are separated by first vertical trench 22 (with the exception that second layer 14 is common to both the PV solar cell stack 15 and blocking diode stack 17). PV solar cell 8 and blocking diode 10 both share a common, first layer 12, and both share a common, second layer 14. Note: the dimensions follow these rules: E < F, F < A, B < C, A < D, C < D, A = E + F, and D = A + B + C. PV solar cell 8 comprises first metal contact 18 disposed on top of PV solar cell stack 15, and blocking diode 10 comprises second metal contact 20 disposed on top of blocking diode stack 17.

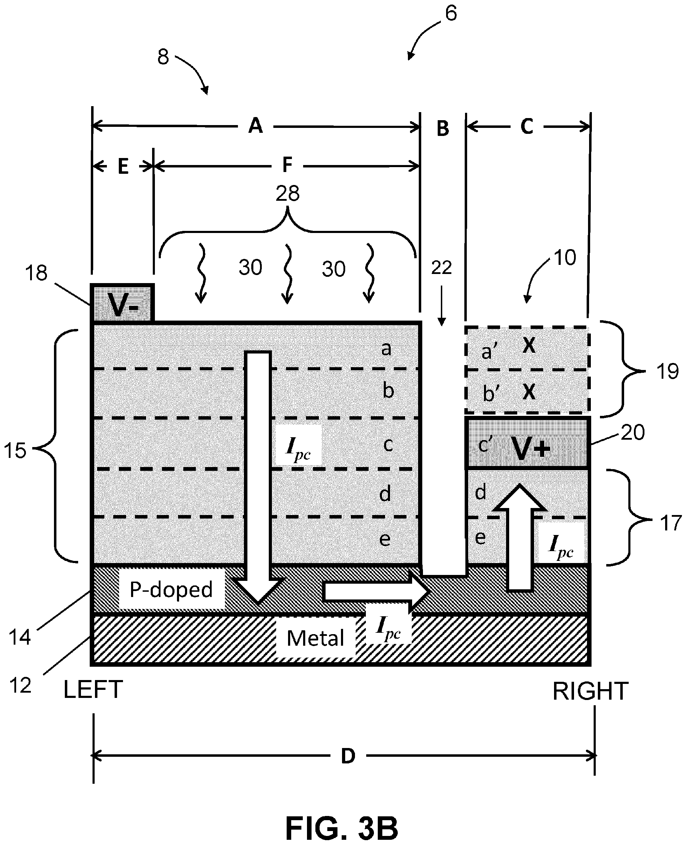

FIG. 3B shows a schematic elevation cross-section view of an example of a PV assembly 6 comprising a generic multi-junction, photovoltaic solar cell 8 with an integrated, monolithic blocking diode 10, wherein the number of layers in the PV solar cell 8 is different (i.e., fewer) than the number of layers in the blocking diode 10, according to the present disclosure. This example is identical to FIG. 3A, except for the following differences. Here, the top two semiconductor layers 19 (i.e., layers a' and b') have been removed (i.e., by selective etching, as represented by the symbol "X"). Second metal contact 20 is then disposed completely across the top of reduced-height blocking diode stack 17'. In this example, reduced-height blocking diode stack 17' comprises, for example, the same bottom-two stacked semiconductor layers (i.e., layers d and e) that are used in the adjacent PV solar cell stack 15. Reduced-height blocking diode stack 17' comprises a fewer number of layers than PV solar cell stack 15 (because upper layers a' and b' have been etched away). PV solar cell 8 and blocking diode 10 both share a same first layer 12 and they share a same second layer 14. PV solar cell 8 comprises first metal contact 18 disposed on top of PV solar cell stack 15 and blocking diode 10 comprises second metal contact 20 disposed completely across the top of reduced-height blocking diode stack 17'.

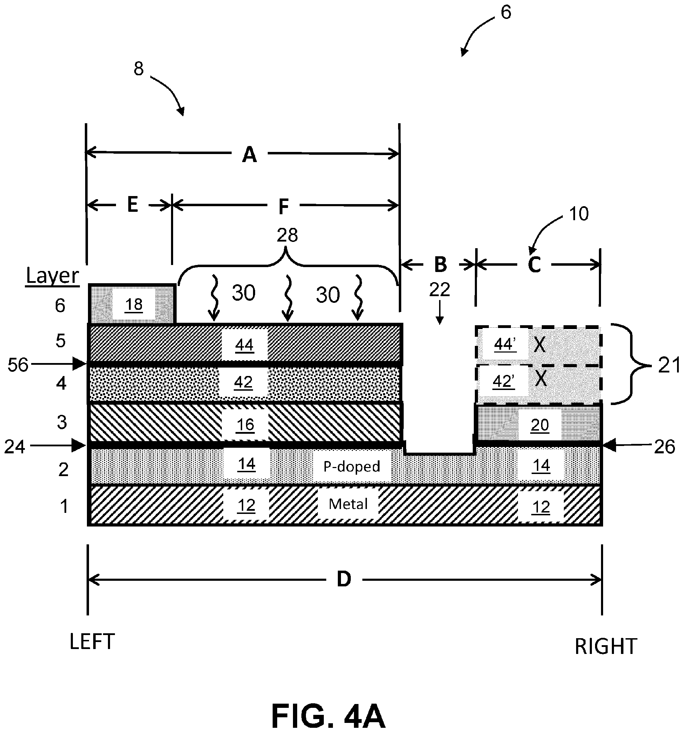

FIG. 4A shows a schematic elevation cross-section view of an example of a dual-junction, integrated, PV assembly 6 comprising a dual-junction, PV solar cell 8 with an integrated, monolithic blocking diode 10, according to the present disclosure. This example is identical to

FIG. 3A, except for the following differences. A fourth layer 42, having a width = A, made of a p-doped second semiconductor material, is disposed on third layer 16. A fifth layer 44, having a width = A, made of a n-doped second semiconductor material, is disposed on fourth layer 42. First vertical trench 22 extends into a top surface of second layer 14. The right-side segments (i.e., stack 21) of layers 16', 42' and 44' of blocking diode 10 have been removed (e.g., by etching). Note: in general, the use of "prime" labels on reference numbers (e.g., 42', 44') refers to layers that are removed (e.g., by etching) from a blocking diode stack to make a "reduced height" blocking diode stack. Second metal contact 20 is disposed on second layer 14. First metal contact 18 is disposed on a left-side portion of fifth layer 44. First PN junction 24 is disposed in between second layer 14 and third layer 16. Second PN junction 26 is disposed in between second layer 14 and second metal contact 20. Third PN junction 56 is disposed in between fourth layer 42 and fifth layer 44. PV solar cell 8 comprises five stacked layers (from top to bottom), comprising: (a) the active solar width or active area 28 (illuminated by sunlight 30) of the n-doped fifth layer 44, (b) the underlying p-doped fourth layer 42, (c) the underlying n-doped third layer 16, (d) the underlying p-doped second layer 14, and (e) the underlying metallic first layer 12. In this example, PV solar cell 8 is a dual-junction solar cell, comprising two stacked PN junctions, 24 and 56, respectively.

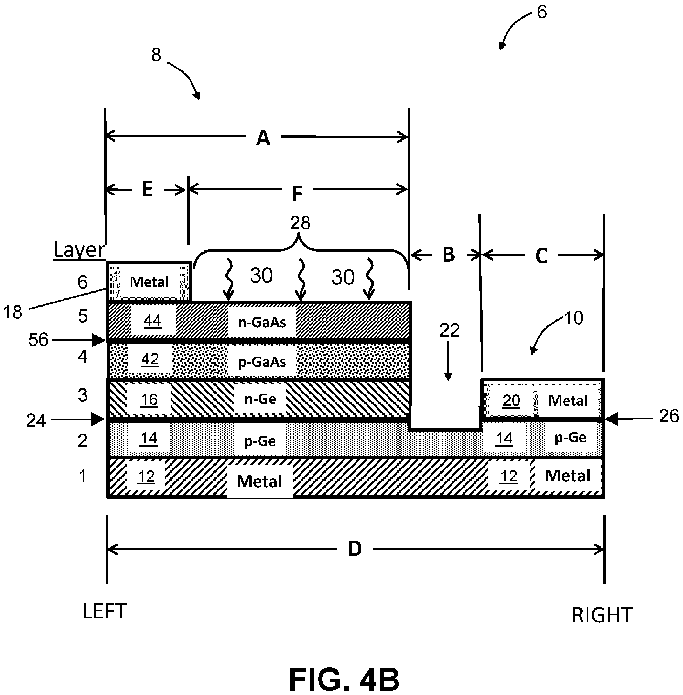

FIG. 4B shows a schematic elevation cross-section view of an example of a single-junction, integrated PV assembly 6 comprising a photovoltaic solar cell 8 with an integrated, monolithic blocking diode 10, using specific material selections, according to the present disclosure. This example is identical to FIG. 4A, except for the following differences. The first layer 12 comprises a metal or metal alloy. The second layer 14 comprises p-Ge. The third layer 16 comprises n-Ge. The fourth layer 42 comprises p-GaAs, and the fifth layer comprises n-GaAs.

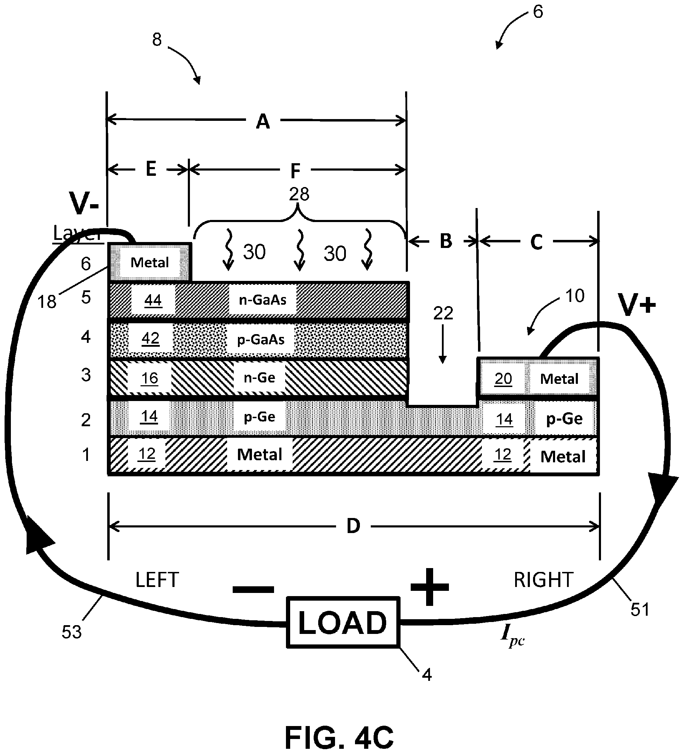

FIG. 4C shows a schematic elevation cross-section view of an example of a single-junction, PV assembly 6 comprising a PV solar cell 8 with an integrated, monolithic blocking diode 10, wherein PV assembly 6 is electrically connected to a load 4, according to the present disclosure. This example is identical to FIG. 4B, except for the following additions. Electrical interconnects (e.g., wires and/or ribbons) 53 and 51 are connected to the first and second metal contacts 18 and 20, respectively, at one end, and connected to lLoad 4 at their other end. First metal contact 18 has a voltage = **V-** and second metal contact 20 has a voltage = V+. Photo current ***I_{pc}*** travels through the PV solar cell 8 from top to bottom (or n-to-p). Then, photo current ***I_{pc}*** travels from bottom to top (or p-to-n) in blocking diode 10. Finally, photocurrent ***I_{pc}*** flows through load 4.

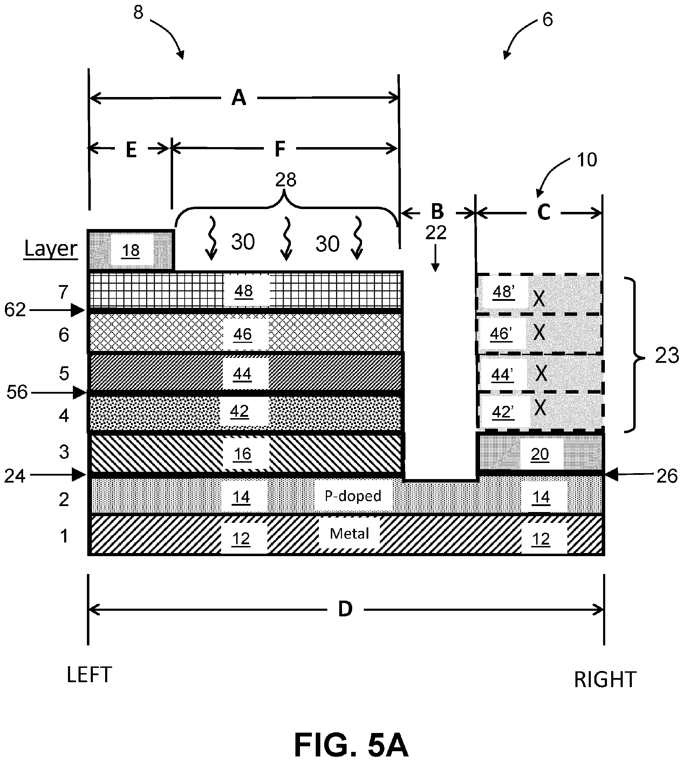

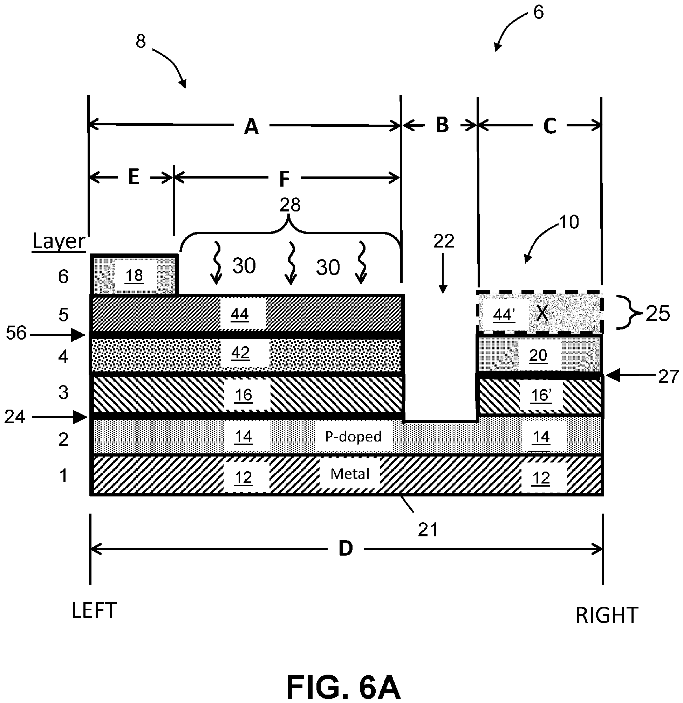

FIG. 5A shows a schematic elevation cross-section view of an example of a triple-junction, integrated, PV assembly 6 comprising a triple-junction, PV solar cell 8 with an integrated, monolithic blocking diode 10, according to the present disclosure. This example is identical to FIG. 6A, except for the following differences. A sixth layer 46, having a width = A, made of a p-doped third semiconductor material, is disposed on fifth layer 44. A seventh layer 48, having a width = A, made of a p-doped third semiconductor material, is disposed on sixth layer 46. First metal contact 18 is disposed on a left-side portion of seventh layer 48. First vertical trench 22 extends into a top surface of second layer 14. The right-side segments (i.e., stack 23) comprising layers 16', 42', 44', 46', and 48' of blocking diode 10 have been removed (e.g., by etching). Second metal contact 20 is disposed on second layer 14, thereby forming a Schottky-type second diode 26. First PN junction 24 is disposed in between second layer 14 and third layer 16. Second PN junction 26 is disposed in between second layer 14 and second metal contact 20. Third PN junction 56 is disposed in between fourth layer 42 and fifth layer 44. Fourth PN junction 62 is disposed in between sixth layer 46 and seventh layer 48. PV solar cell 8 comprises seven stacked layers (from top to bottom), comprising: (a) the active solar width or active area 28 (illuminated by sunlight 30) of the n-doped seventh layer 48, (b) the underlying p-doped sixth layer 46, (c) the underlying n-doped fifth layer 44, (d) the underlying p-doped fourth layer 42, (e) the underlying n-doped third layer 16, (f) the underlying p-doped second layer 14, and (g) the underlying metal first layer 12. In this example, PV solar cell 8 is a triple junction solar cell, comprising three stacked PN junctions, 24, 56, and 62, respectively.

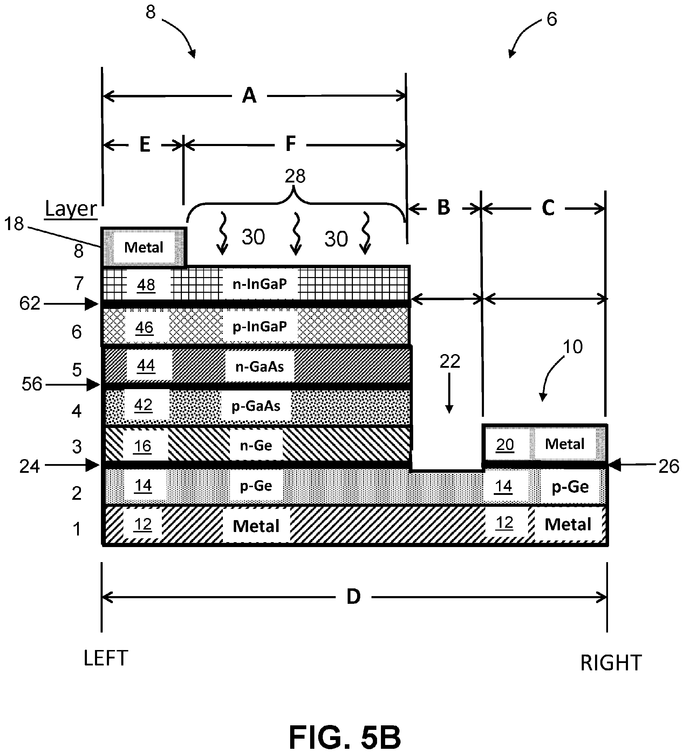

FIG. 5B shows a schematic elevation cross-section view of an example of a triple-junction, integrated PV assembly 6 comprising a photovoltaic solar cell 8 with an integrated, monolithic blocking diode 10, using specific material selections, according to the present disclosure. This example is identical to FIG. 5A, except for the following differences. The first layer 12 comprises a metal or metal alloy. The second layer 14 comprises p-Ge. The third layer 16 comprises n-Ge. The fourth layer 42 comprises p-GaAs. The fifth layer 44 comprises n-GaAs. The sixth layer 46 comprises n-InGaP, and the seventh layer 48 comprises p-InGaP. The third semiconductor material can comprise doped InGaP.

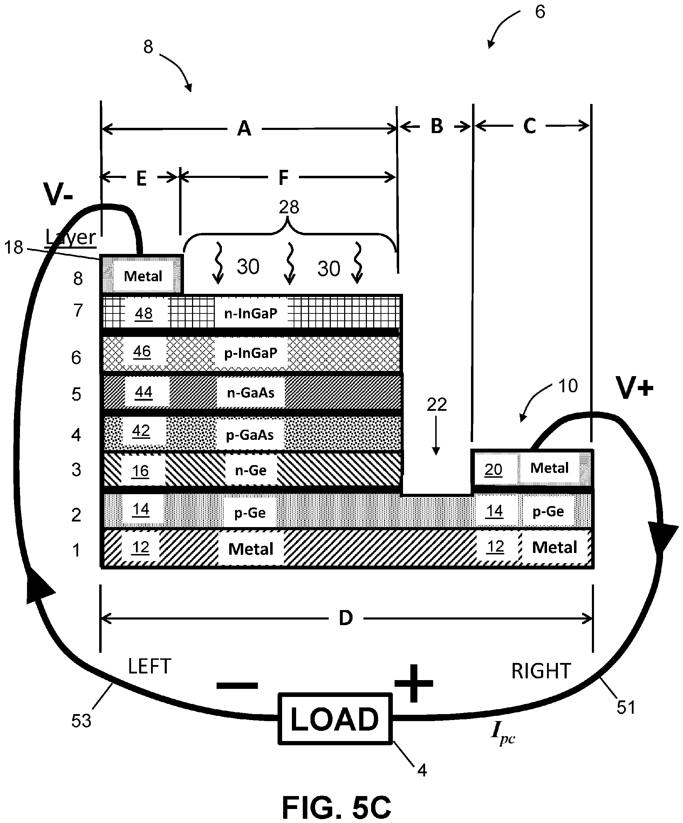

FIG. 5C shows a schematic elevation cross-section view of an example of a triple-junction, PV assembly 6 comprising a PV solar cell 8 with an integrated, monolithic blocking diode 10, wherein PV assembly 6 is electrically connected to a Load 4, according to the present disclosure. This example is identical to FIG. 5B, except for the following additions. Electrical interconnects (e.g., wires and/or ribbons) 53 and 51 are connected to the first and second metal contacts 18 and 20, respectively, at one end, and connected to Load 4 at their other end. First metal contact 18 has a voltage = **V-** and second metal contact 20 has a voltage = V+. Photo current ***I_{pc}*** travels through the PV solar cell 8 from top to bottom (or n-to-p). Then, photo current ***I_{pc}*** travels from bottom to top (or p-to-n) in blocking diode 10. Finally, photocurrent ***I_{pc}*** flows through load 4.

FIG. 6A shows a schematic elevation cross-section view of an example of a double-junction, integrated, PV assembly 6 comprising a single-junction, PV solar cell 8 with an integrated, monolithic blocking diode 10, according to the present disclosure. A fourth layer 42, having a width = A, made of a p-doped second semiconductor material, is disposed above the third layer 16. A fifth layer 44, having a width = A, made of a n-doped second semiconductor material, is disposed above the fourth layer 42. First metal contact 18 is disposed on a left-side portion of fifth layer 44. First vertical trench 22 extends into a top surface of second layer 14. The right-side segments (i.e., stack 25) of layers 42' and 44' of blocking diode 10 have been removed (e.g., by etching). Second metal contact 20 is disposed on right-side segment 16' of third layer 16. PV solar cell 8 comprises five stacked layers (from top to bottom), comprising: (a) the active solar width or active area 28 (illuminated by sunlight 30) of the n-doped fifth layer 44, (b) the underlying p-doped fourth layer 42, (c) the underlying n-doped third layer 16, (d) the underlying p-doped second layer 14, and (e) the underlying metallic first layer 12. The integrated, monolithic blocking diode 10 comprises the second metal contact 20, which overlays right-side segment 16', which overlays second layer 14, and which overlays first layer 12. PV solar cell 8 and blocking diode 10 both share a first layer 12 and a common second layer 14. In this example, PV solar cell 8 is a dual-junction solar cell, comprising two stacked PN junctions, 24 and 56, respectively.

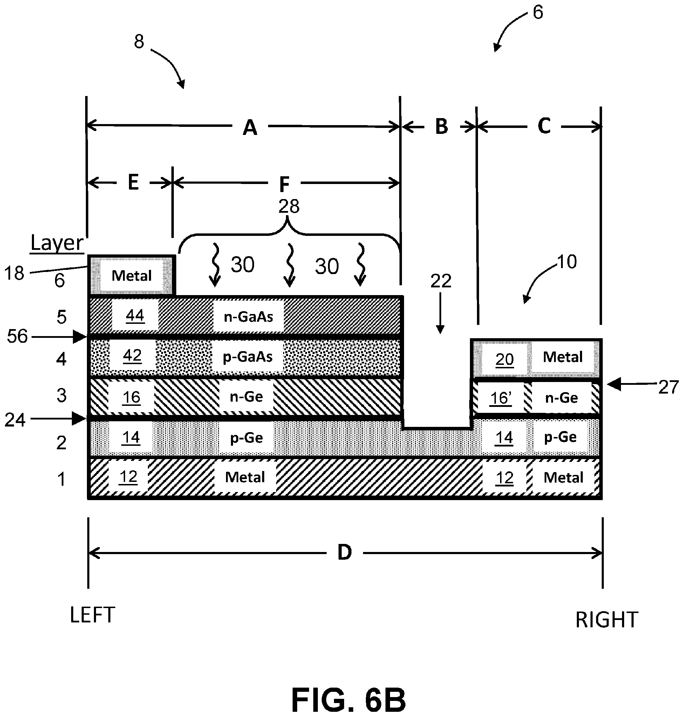

FIG. 6B shows a schematic elevation cross-section view of an example of a double-junction, integrated PV assembly 6 comprising a photovoltaic solar cell 8 with an integrated, monolithic blocking diode 10, using specific material selections, according to the present disclosure. This example is identical to FIG. 6A, except for the following differences. The first layer 12 comprises a metal or metal alloy, the second layer 14 comprises p-germanium, the third layers 16 and 16' both comprise n-germanium, the fourth layer 42 comprises p-GaAs, the fifth layer 44 comprises n-GaAs, and first and second metal contacts 18 and 20 comprise a metal or metal alloy.

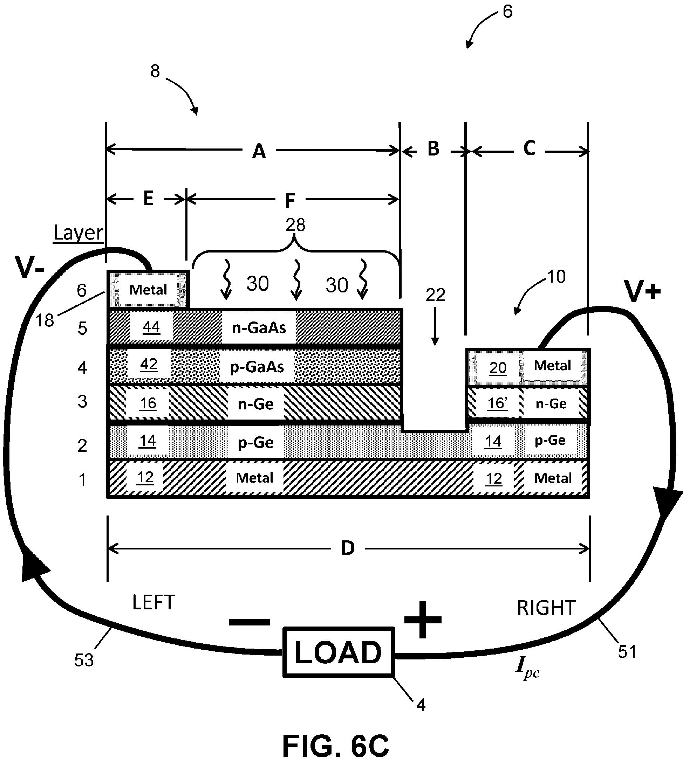

FIG. 6C shows a schematic elevation cross-section view of an example of a double-junction, PV assembly 6 comprising a PV solar cell 8 with an integrated, monolithic blocking diode 10, wherein PV assembly 6 is electrically connected to a Load 4, according to the present disclosure. This example is identical to FIG. 6B, except for the following additions. Electrical interconnects (e.g., wires and/or ribbons) 53 and 51 are connected to the first and second metal contacts 18 and 20, respectively, at one end, and connected to Load 4 at their other end. First metal contact 18 has a voltage = **V-** and second metal contact 20 has a voltage = V+. Photo current ***I_{pc}*** travels through the PV solar cell 8 from top to bottom (or n-to-p). Then, photo current ***I_{pc}*** travels from bottom to top (or p-to-n) in blocking diode 10. Finally, photocurrent ***I_{pc}*** flows through load 4.

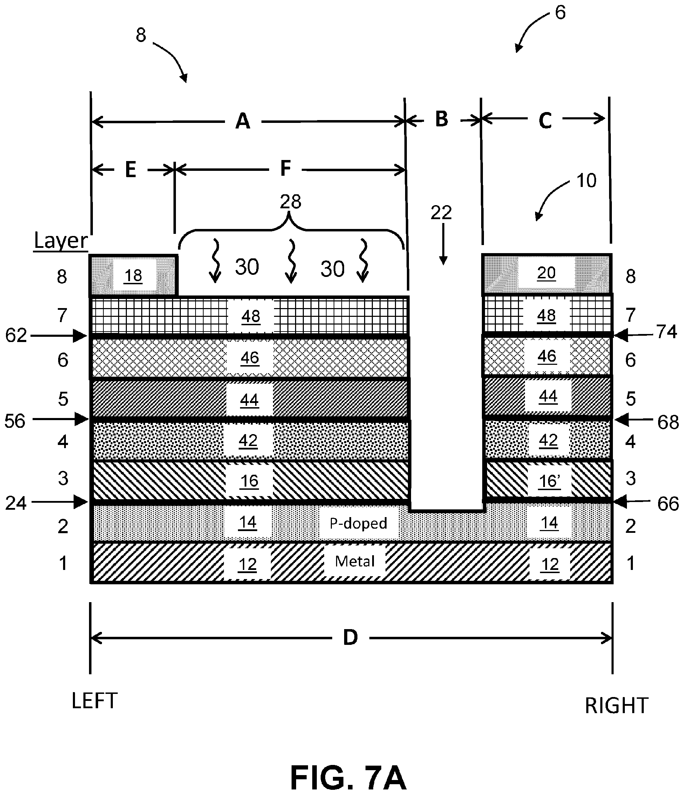

FIG. 7A shows a schematic elevation cross-section view of an example of a triple-junction, integrated, PV assembly 6 comprising a triple-junction, PV solar cell 8 with an integrated, monolithic blocking diode 10, according to the present disclosure. This example is identical to FIG. 5A, except for the following differences. A sixth layer 46, having a width = A, made of a p-doped third semiconductor material, is disposed on fifth layer 44. A seventh layer 48, having a width = A, made of a n-doped third semiconductor material, is disposed on sixth layer 46. First metal contact 18 is disposed on a left-side portion of seventh layer 48. Fourth PN junction 62 is disposed in between sixth layer 46 and seventh layer 48. PV solar cell 8 comprises seven stacked layers (from top to bottom), comprising: (a) the active solar width or active area 28 (illuminated by sunlight 30) of the n-doped seventh layer 48, (b) the underlying p-doped sixth layer 46, (c) the underlying n-doped fifth layer 44, (d) the underlying p-doped fourth layer 42, (e) the underlying n-doped third layer 16, (f) the underlying p-doped second layer 14, and (g) the underlying metal first layer 12.

Referring still to FIG. 7A, the integrated, monolithic blocking diode 10 comprises eight stacked layers (from top to bottom), comprising: (a) the second metal contact 20, which is disposed above the seventh layer 48, which is disposed above the sixth layer 46, which is disposed above the fifth layer 44, which is disposed above the fourth layer 42, which is disposed above the third layer (i.e., right-side segment 16'), which is disposed above the second layer 14, and which is disposed above the first layer 12. In this example, PV solar cell 8 is a triple junction solar cell, comprising three stacked PN junctions, 24, 56, and 62, respectively. Likewise, blocking diode 10 comprises three stacked PN junctions, 66, 68, and 74, respectively.

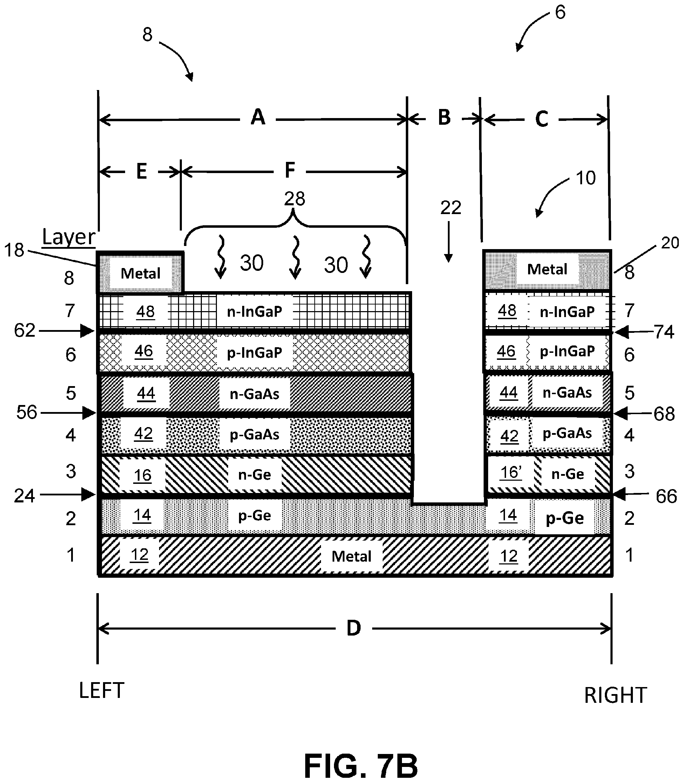

FIG. 7B shows a schematic elevation cross-section view of a triple-junction, integrated PV assembly 6 comprising a photovoltaic solar cell 8 with an integrated, monolithic blocking diode 10, using specific material selections, according to the present disclosure. This example is identical to FIG. 5B, except for the following differences. The first layer 12 comprises a metal or metal alloy. The second layer 14 comprises p-Ge. The third layer 16 and 16' comprises n-Ge.

The fourth layer 42 comprises p-GaAs. The fifth layer 44 comprises n-GaAs. The sixth layer 46 comprises p-InGaP, and the seventh layer 48 comprises n-InGaP. The third semiconductor material can comprise doped InGaP. The turn-on voltage of this triple-junction blocking diode 10 is approximately = 2 V.

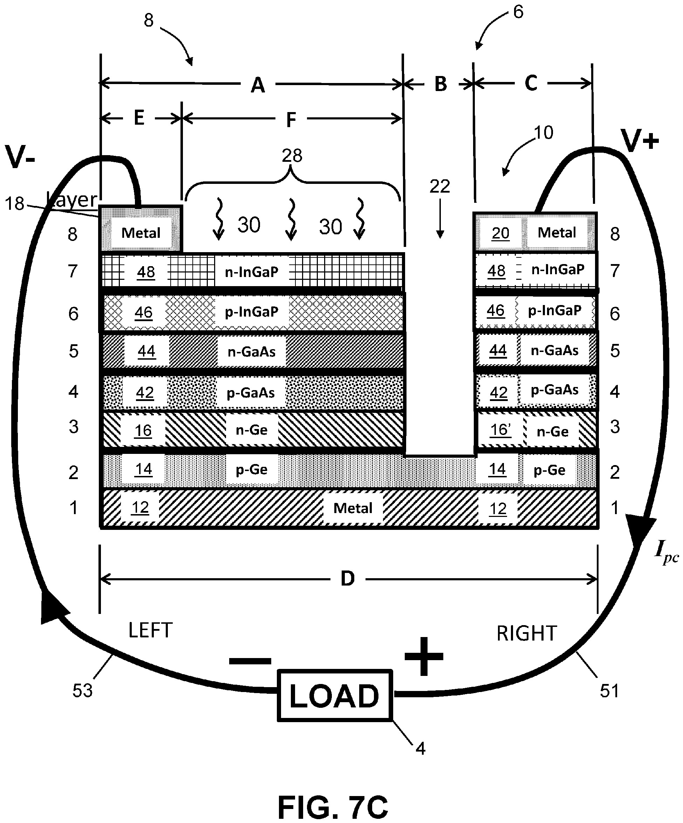

FIG. 7C shows a schematic elevation cross-section view of an example of a triple-junction, PV assembly 6 comprising a PV solar cell 8 with an integrated, monolithic blocking diode 10, wherein PV assembly 6 is electrically connected to a Load 4, according to the present disclosure. This example is identical to FIG. 5C, except for the following additions. Electrical interconnects (e.g., wires and/or ribbons) 53 and 51 are connected to the first and second metal contacts 18 and 20, respectively, at one end, and connected to Load 4 at their other end. First metal contact 18 has a voltage = **V-** and second metal contact 20 has a voltage = V+. Photo current ***I_{pc}*** travels through the PV solar cell 8 from top to bottom (or n-to-p). Then, photo current ***I_{pc}*** travels from bottom to top (or p-to-n) in blocking diode 10. Finally, photocurrent ***I_{pc}*** flows through load 4.

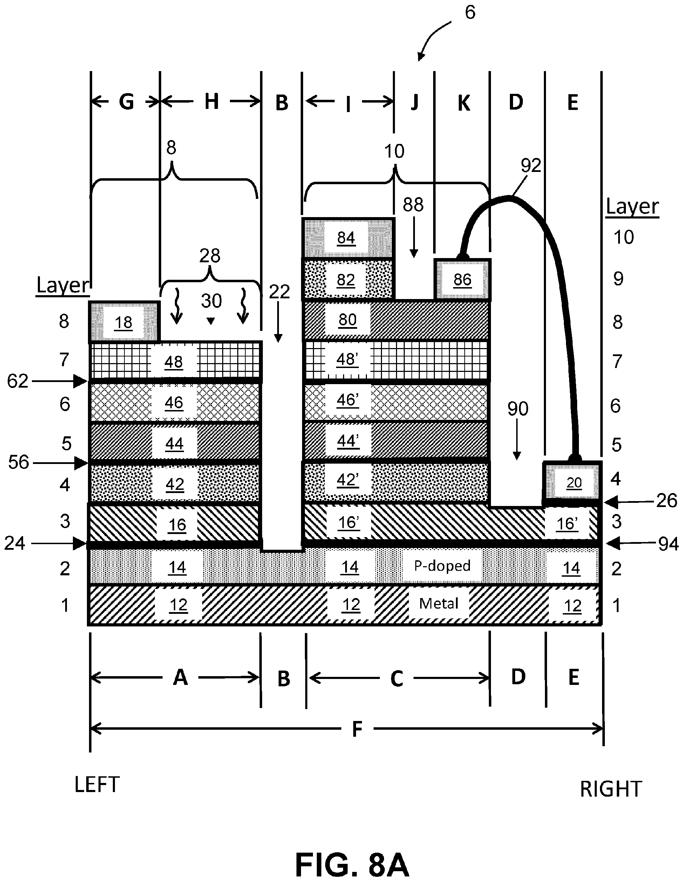

FIG. 8A shows a schematic elevation cross-section view of an example of a triple-junction, integrated, PV assembly 6 comprising a triple-junction, PV solar cell 8 with an integrated, monolithic blocking diode 10, according to the present disclosure. First layer 12, having a width = F, is made of an electrically conductive material, such as a metal or metal alloy. Second layer 14, having a width = F, is made of a p-doped first semiconductor material, which is disposed on first layer 12. A left-side segment 16 of third layer 16, having a width = A, is made of a n-doped first semiconductor material that is disposed above the second layer 14. A right-side segment 16' of third layer 16, having a width = C + D + E, is made of the n-doped first semiconductor material that is disposed on second layer 14. First vertical trench 22, which extends into the top of second layer 14, divides the left-side segment 16 from the right-side segment 16' of layer 16. Second metal contact 20, having a width = E, is disposed on a portion of right-side segment 16' above the right-side of PV assembly 6, wherein E < F and E < C.

Referring still to FIG. 8A, PV solar cell 8 comprises (from top to bottom) a stack of eight layers, including: (a) a first metal contact 18, having a width = G, (b) a seventh layer 48, having a width = A, comprising a n-doped third semiconductor material, including an active solar width or active area 28 (illuminated by sunlight 30), having a width = H, wherein A = G + H, (c) a sixth layer 46, having a width = A, made of a p-doped third semiconductor material, (d) a fifth layer 44, having a width = A, made of a n-doped second semiconductor material, (e) a fourth layer 42, having a width = A, made of a p-doped second semiconductor material, (f) a left-side segment 16 of a third layer 16, having a width = A, made of a n-doped first semiconductor material, (g) a second layer 44, having a width = F, made of a p-doped first semiconductor material, and (h) a first layer 12, having a width = F, made of metal or metal alloy. Note: F = A + B + C + D + E.

Referring still to FIG. 8A, blocking diode 10 comprises (from top to bottom) a stack often layers, including: (a) a third metal contact 84 having width = I, made of a metal or metal alloy, (b) a ninth layer 82, having a width = I, made from a p-doped second semiconductor material that is disposed on a portion of the eighth layer 80, (c) an eighth layer 80, having a width = C, made from a n-doped third semiconductor material, (d) a seventh layer 48', having a width = C, made from a p-doped third semiconductor material, (e) a sixth layer 46', having a width = C, made from a p-doped third semiconductor material, (f) a fifth layer 44', having a width = C, made from a n-doped second semiconductor material, (g) a fourth layer 42', having a width = C, made from a p-doped second semiconductor material, (h) a third layer 16', having a width = C + D + E, made from a n-doped first semiconductor material, (i) a second layer 14, having a width = F, made from a p-doped first semiconductor material, and (j) a first layer 12, having a width = F, made from a metal or metal alloy.

Referring still to FIG. 8A, second vertical trench 90 is disposed in between fourth layer 42 and second metal contact 20 and extends into the top of right-side segment 16'. Blocking diode 10, having a width = C, is disposed in between first and second vertical trenches 22 and 90, respectively. Third metal contact 84, having width = I, is disposed above and completely across ninth layer 82, and is made of a metal or metal alloy. Fourth metal contact 86, having a width = K, wherein K < C, is disposed on a right-side of eighth layer 80, and is made of a metal or metal alloy. Third vertical trench 88, having a width = J, wherein J < C, is disposed in between ninth layer 82 and fourth metal contact 86. Conductive metal shunt 92, which can be a wire or ribbon, electrically interconnects second metal contact 20 to fourth metal contact 86. PV solar cell 8 and blocking diode 10 both share a first layer 12 and a common second layer 14. In this example, PV solar cell 8 is a triple-junction cell, having a first PN junction 24, a third PN junction 56, and a fourth PN junction 62.

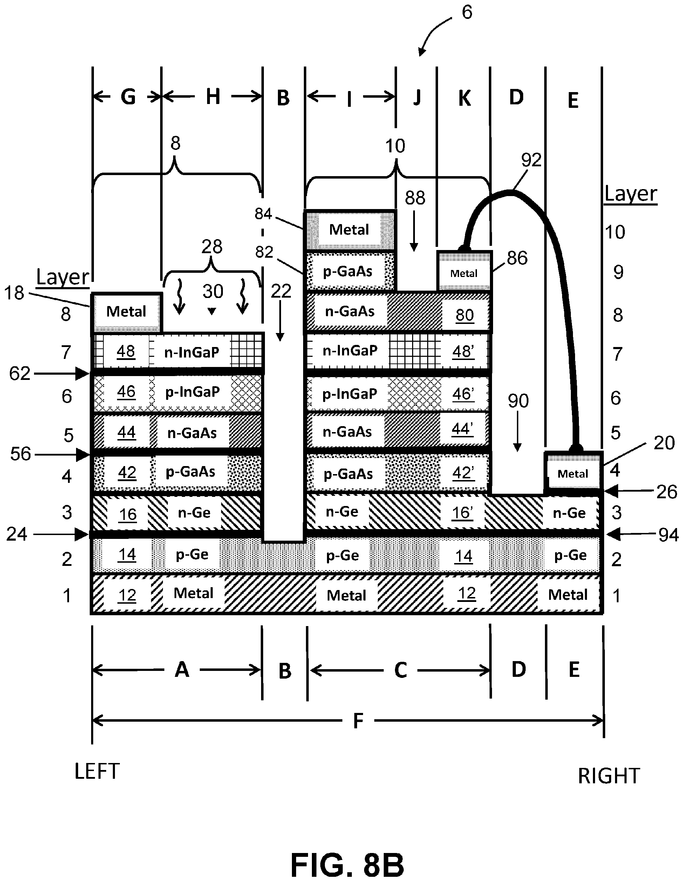

FIG. 8B shows a schematic elevation cross-section view of an example of a triple-junction, integrated PV assembly 6 comprising a photovoltaic solar cell 8 with an integrated, monolithic blocking diode 10, using specific material selections, according to the present disclosure. This example is identical to FIG. 8A, except for the following differences. The first layer 12 comprises a metal or metal alloy. The second layer 14 comprises p-Ge. The third layers 16 and 16' comprise n-Ge. The fourth layer 42 comprises p-GaAs. The fifth layer 44 comprises n-GaAs. The sixth layer 46 comprises p-InGaP. The seventh layer 48 comprises n-InGaP. The eighth layer 80 comprises n-GaAs. The ninth layer 82 comprises p-GaAs. The third metal contact 84 comprises a metal or metal alloy. The first semiconductor material comprises germanium, the second semiconductor material comprises GaAs, and the third semiconductor material comprises InGaP. The turn-on voltage of this blocking diode 10 is approximately 1 V.

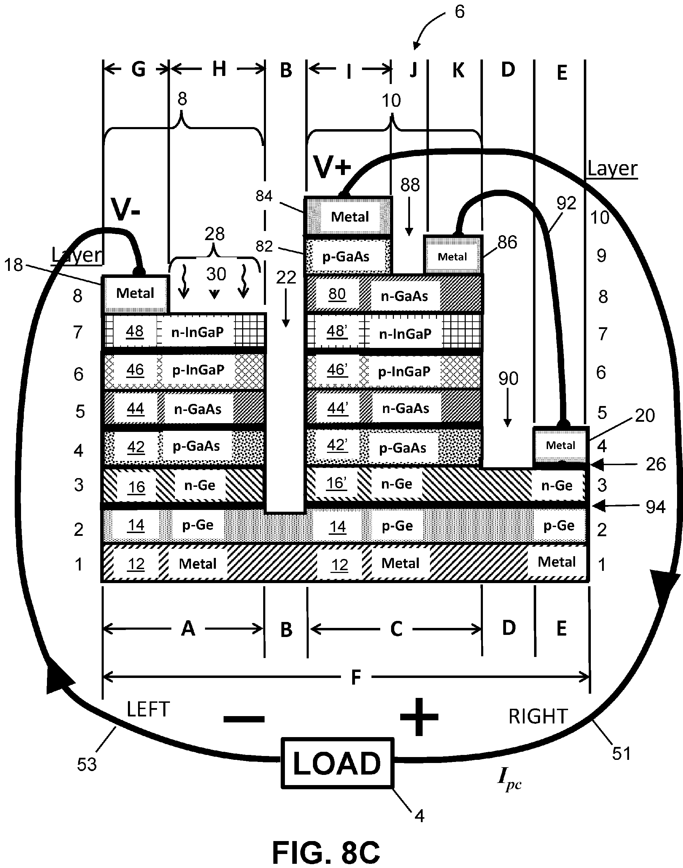

FIG. 8C shows a schematic elevation cross-section view of an example of a triple-junction, PV assembly 6 comprising a PV solar cell 8 with an integrated, monolithic blocking diode 10, wherein PV assembly 6 is electrically connected to a Load 4, according to the present disclosure. This example is identical to FIG. 8B, except for the following additions. Electrical interconnects (e.g., wires and/or ribbons) 53 and 51 are connected to the first and third metal contacts 18 and 84, respectively, at one end, and connected to Load 4 at their other end. First metal contact 18 has a voltage = **V-** and third metal contact 84 has a voltage = V+. Photo current ***I_{pc}*** travels through the PV solar cell 8 from top to bottom (or n-to-p). Then, photo current ***I_{pc}*** travels from bottom to top (or p-to-n) in blocking diode 10. Finally, photocurrent ***I_{pc}*** flows through load 4.

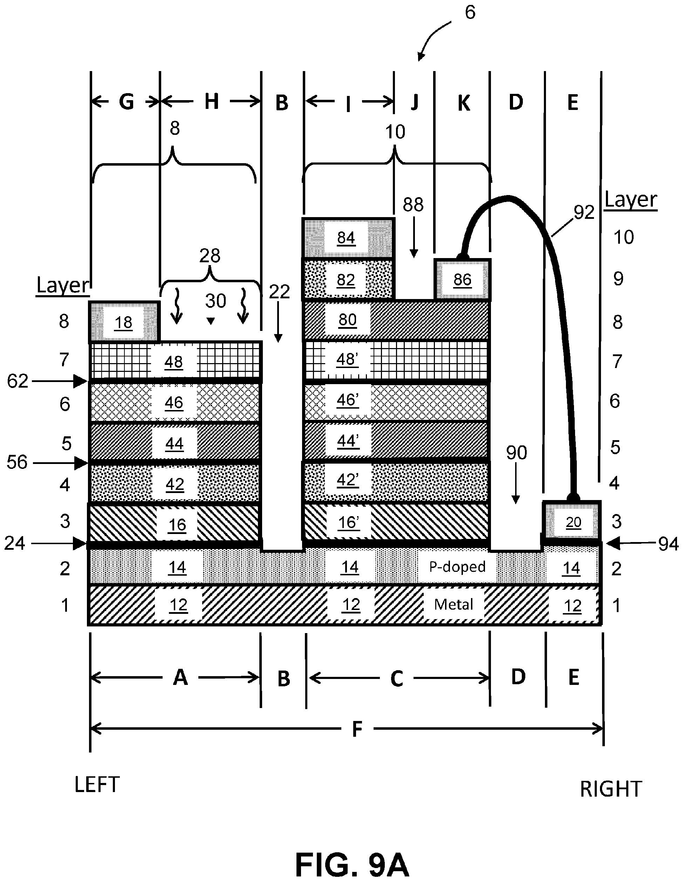

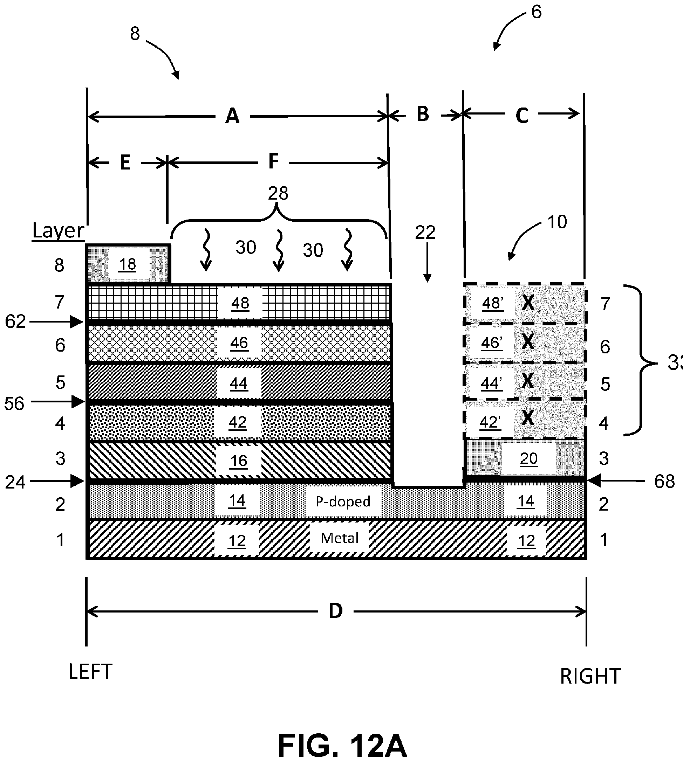

FIG. 9A shows a schematic elevation cross-section view of an example of a triple-junction, integrated, PV assembly 6 comprising a triple-junction, PV solar cell 8 with an integrated, monolithic blocking diode 10, according to the present disclosure. This example is identical to that shown in FIG. 12A, with the following difference. A portion of the extreme right-side of right-side segment 16' of third layer 16 has been removed (e.g., by etching) and second metal contact 20 is disposed directly on second layer 14.

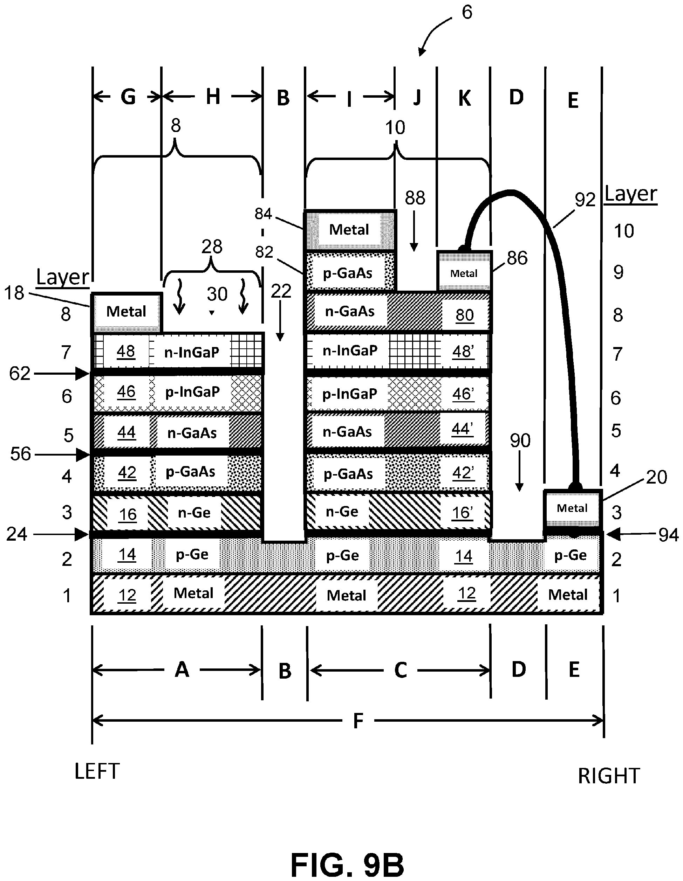

FIG. 9B shows a schematic elevation cross-section view of a triple-junction, integrated PV assembly 6 comprising a photovoltaic solar cell 8 with an integrated, monolithic blocking diode 10, using specific material selections, according to the present disclosure. This example is identical to FIG. 9A, except for the following differences. The first layer 12 comprises a metal or metal alloy. The second layer 14 comprises p-Ge. The third layers 16 and 16' comprise n-Ge. The fourth layer 42 comprises p-GaAs. The fifth layer 44 comprises n-GaAs. The sixth layer 46 comprises p-InGaP. The seventh layer 48 comprises n-InGaP. The eighth layer 80 comprises n-GaAs. The ninth layer 82 comprises p-GaAs. The third metal contact 84 comprises a metal or metal alloy. The first semiconductor material comprises germanium, the second semiconductor material comprises GaAs, and the third semiconductor material comprises InGaP. PN junction 94 comprises a Schottky diode with a turn on voltage of about 1 V.

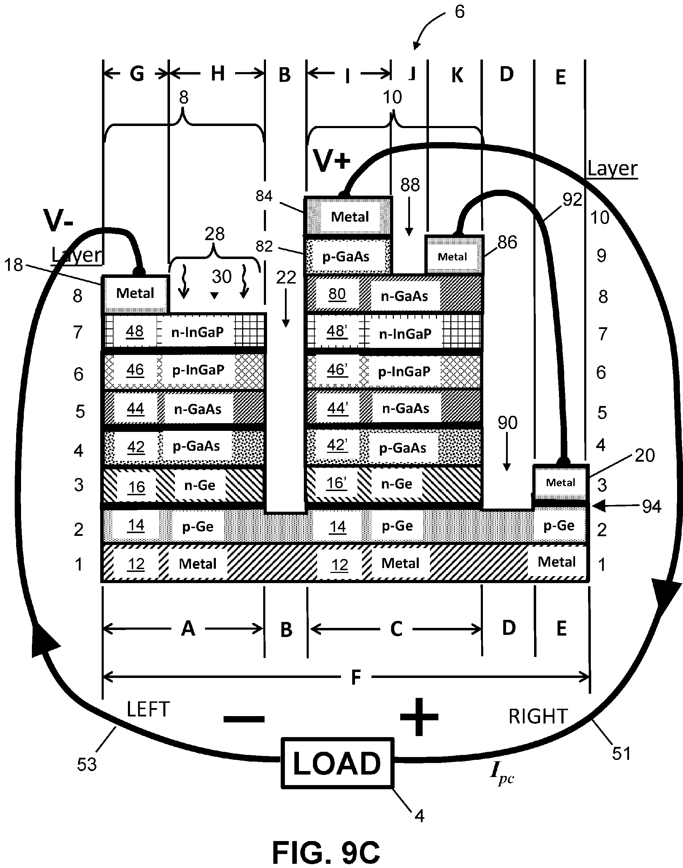

FIG. 9C shows a schematic elevation cross-section view of an example of a triple-junction, PV assembly 6 comprising a PV solar cell 8 with an integrated, monolithic blocking diode 10, wherein PV assembly 6 is electrically connected to a Load 4, according to the present disclosure. This example is identical to FIG. 9B, except for the following additions. Electrical interconnects (e.g., wires and/or ribbons) 53 and 51 are connected to the first and third metal contacts 18 and 84, respectively, at one end, and connected to Load 4 at their other end. First metal contact 18 has a voltage = **V-** and third metal contact 84 has a voltage = V+. Photo current ***I_{pc}*** travels through the PV solar cell 8 from top to bottom (or n-to-p). Then, photo current ***I_{pc}*** travels from bottom to top (or p-to-n) in blocking diode 10. Finally, photocurrent ***I_{pc}*** flows through load 4.

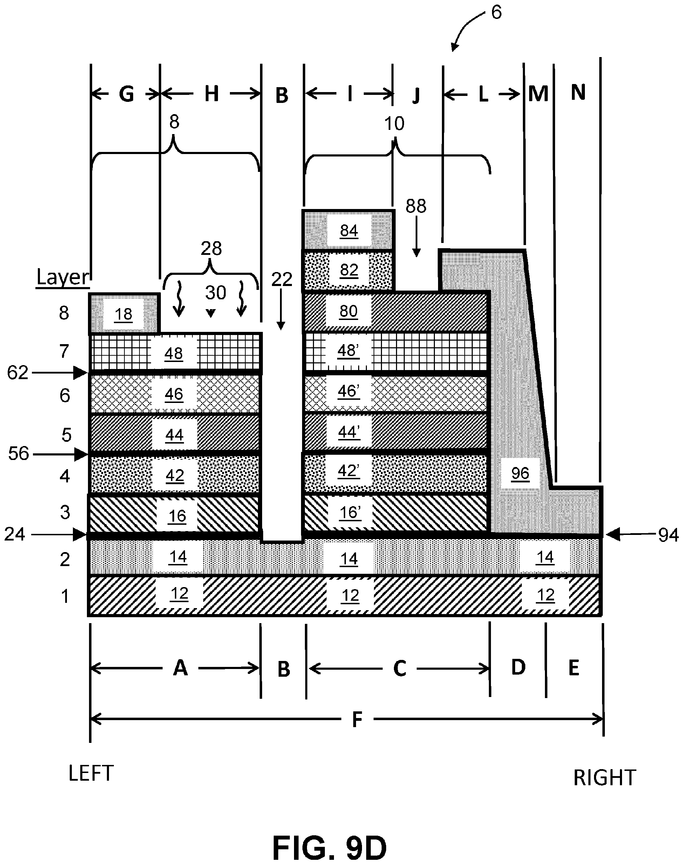

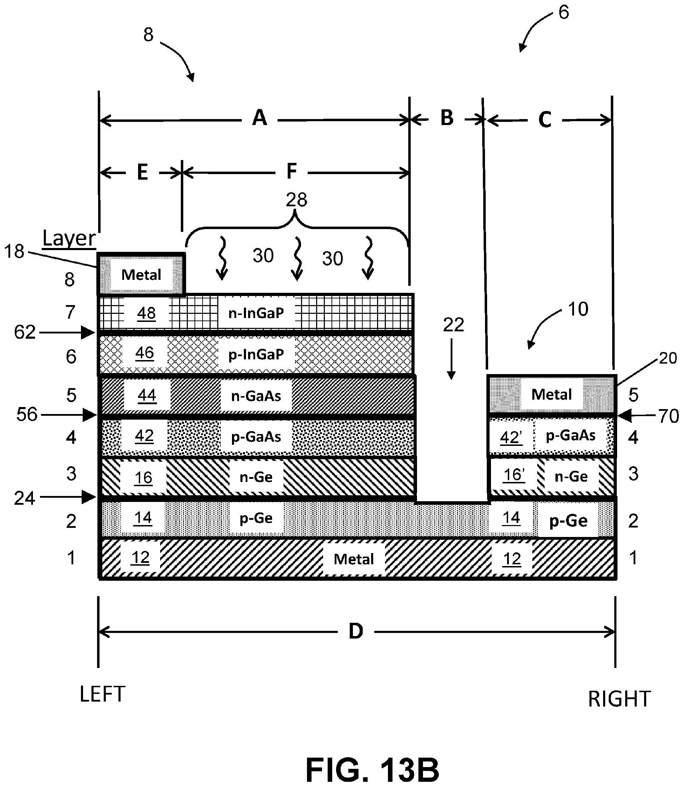

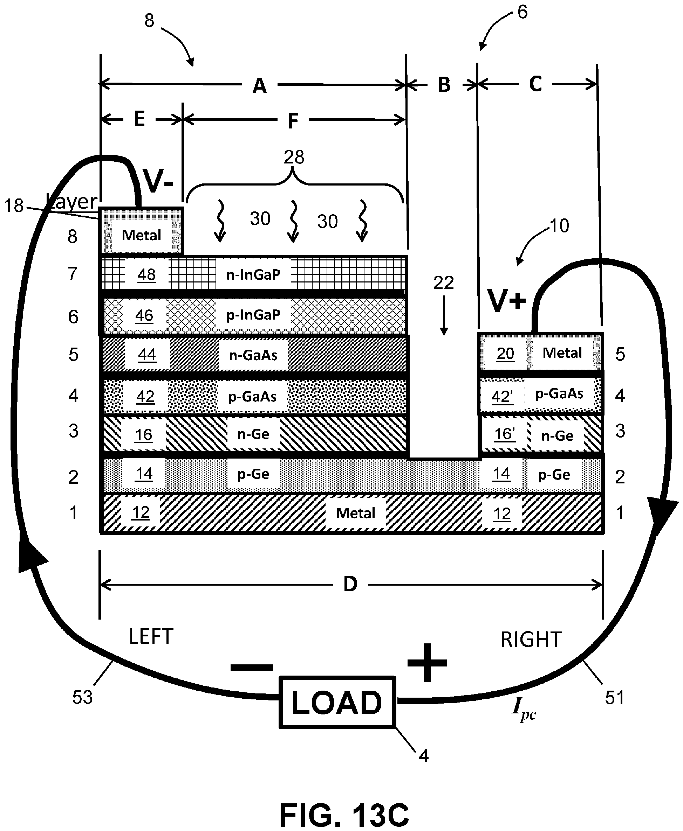

FIG. 9D shows a schematic elevation cross-section view of an example of a triple-junction, integrated, PV assembly 6 comprising a triple-junction, PV solar cell 8 with an integrated, monolithic blocking diode 10, according to the present disclosure. This example is identical to that shown in FIG. 9C, with the following difference. Metal shunt 92 from FIG. 13C is replaced by an integrated, monolithic, metal shunt 96, which electrically interconnects the upper surface of eighth layer 80 to the upper surface of second layer 14. The configurations shown in FIGS. 13B and 13D are electrically identical.

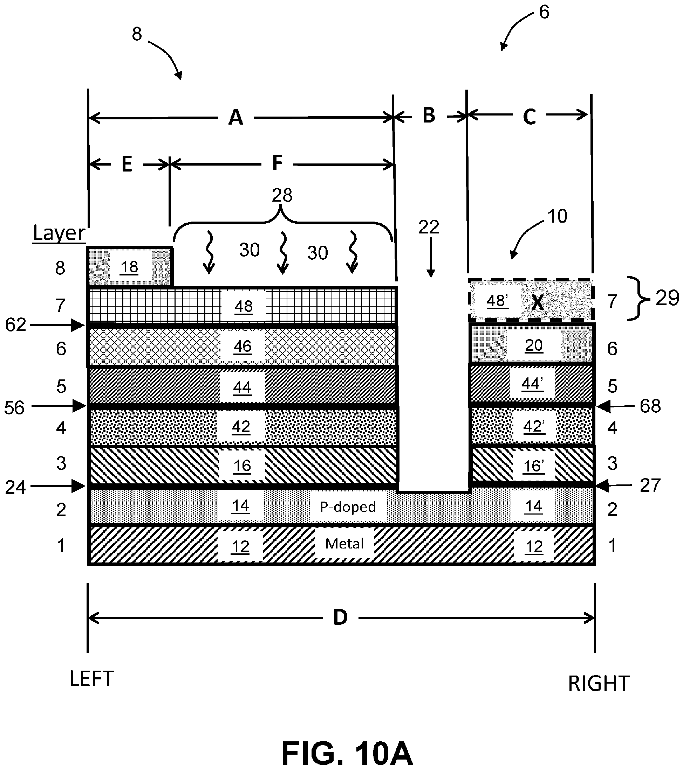

FIG. 10A shows a schematic elevation cross-section view of an example of a triple-junction, integrated, PV assembly 6 comprising a triple-junction, PV solar cell 8 with an integrated, monolithic blocking diode 10, according to the present disclosure. This example is identical to FIG. 7A, except for the following differences. First vertical trench 22 extends into a top surface of second layer 14. The right-side segments (i.e., stack 29) of layers 46' and 48' of blocking diode 10 have been removed (e.g., by etching). Second metal contact 20 is disposed above the fifth layer 44'. The integrated, monolithic blocking diode 10 comprises six stacked layers (from top to bottom), comprising: (a) the second metal contact 20, which is disposed on (b) the fifth layer 44', which is disposed on (c) the fourth layer 42', which is disposed above the (d) third layer (i.e., right-side segment) 16', which is disposed on (e) the second layer 14, and which is disposed on (f) the first layer 12. Blocking diode 10 comprises two stacked PN junctions, 27 and 68, respectively.

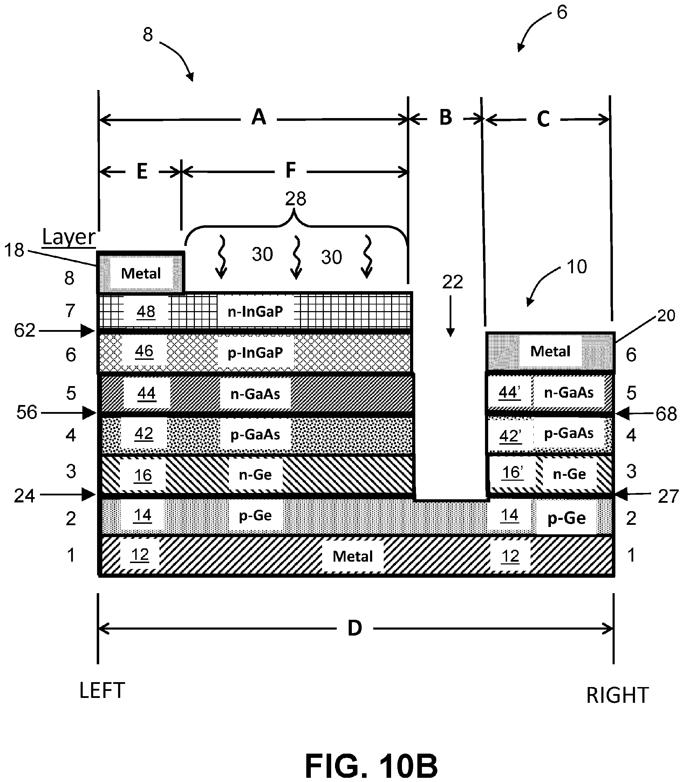

FIG. 10B shows a schematic elevation cross-section view of an example of a triple-junction, integrated PV assembly 6 comprising a photovoltaic solar cell 8 with an integrated, monolithic blocking diode 10, using specific material selections, according to the present disclosure. This example is identical to FIG. 10A, except for the following differences. The first layer 12 comprises a metal or metal alloy. The second layer 14 comprises p-Ge. The third layers 16 and 16' comprise n-Ge. The fourth layers 42 and 42' comprise p-GaAs. The fifth layers 44 and 44' comprise n-GaAs. The sixth layer 46 comprises p-InGaP. The seventh layer 48 comprises n-InGaP. The right-side segments of the InGaP top cell layers 46' and 48' of blocking diode 10 have been removed (e.g., by etching).

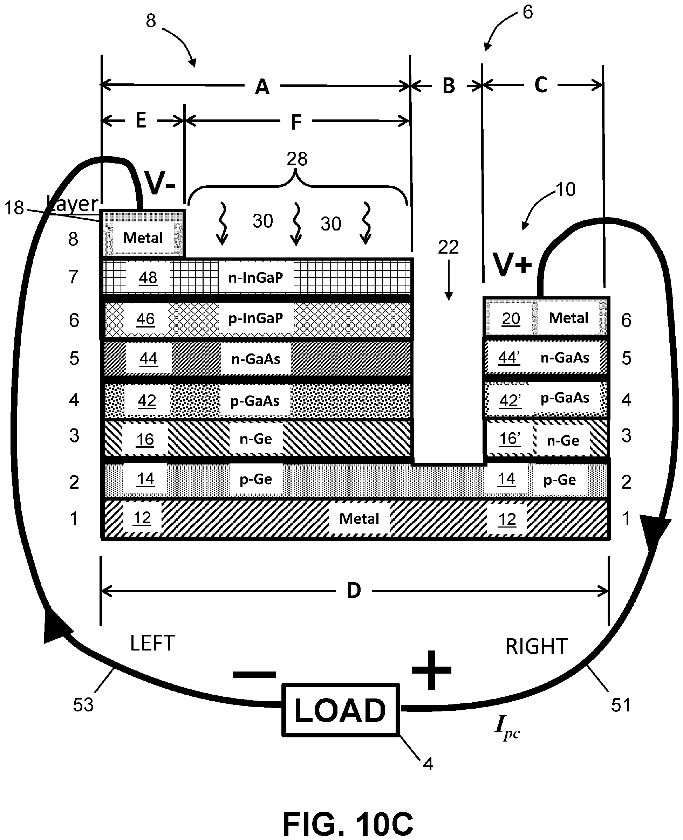

FIG. 10C shows a schematic elevation cross-section view of an example of a triple-junction, PV assembly 6 comprising a PV solar cell 8 with an integrated, monolithic blocking diode 10, wherein PV assembly 6 is electrically connected to a load 4, according to the present disclosure. This example is identical to FIG. 10B, except for the following additions. Electrical interconnects (e.g., wires and/or ribbons) 53 and 51 are connected to the first and second metal contacts 18 and 20, respectively, at one end, and connected to load 4 at their other end. First metal contact 18 has a voltage = **V-** and second metal contact 20 has a voltage = V+. The turn-on voltage of this dual-junction blocking diode 10 is approximately = 1 V.

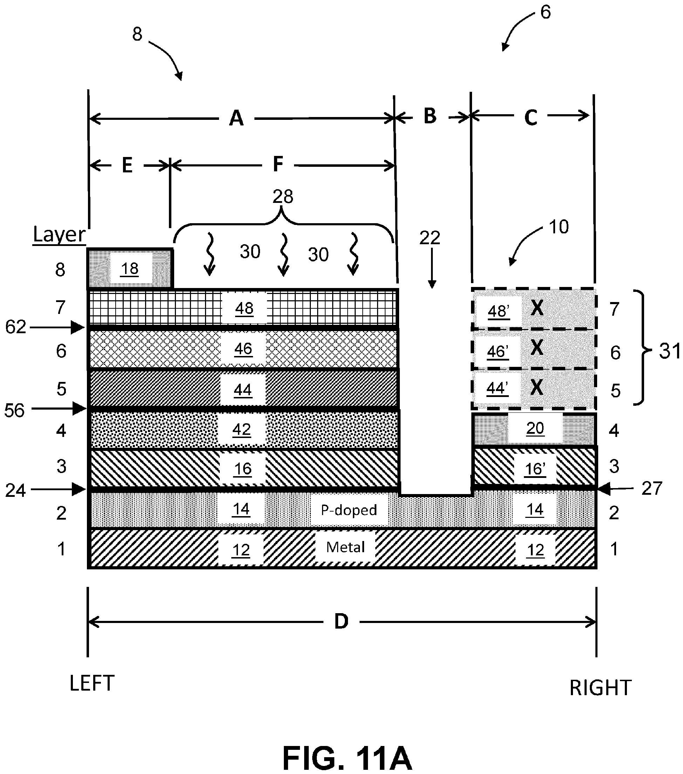

FIG. 11A shows a schematic elevation cross-section view of an example of a triple-junction, integrated, PV assembly 6 comprising a triple-junction, PV solar cell 8 with an integrated, monolithic blocking diode 10, according to the present disclosure. This example is identical to FIG. 10A, except for the following differences. First vertical trench 22 extends into a top surface of second layer 14. The right-side segments (i.e., stack 31) of layers 44', 46', and 48' of blocking diode 10 have been removed (e.g., by etching). Second metal contact 20 is disposed on right-side segment 16' of the third layer 16. The integrated, monolithic blocking diode 10 comprises four stacked layers (from top to bottom), comprising: (a) the second metal contact 20, which is disposed on (b) right-side segment 16' of the third layer 16, which is disposed on (c) second layer 14, and which is disposed on (d) first layer 12. Blocking diode 10 comprises PN junction 27.

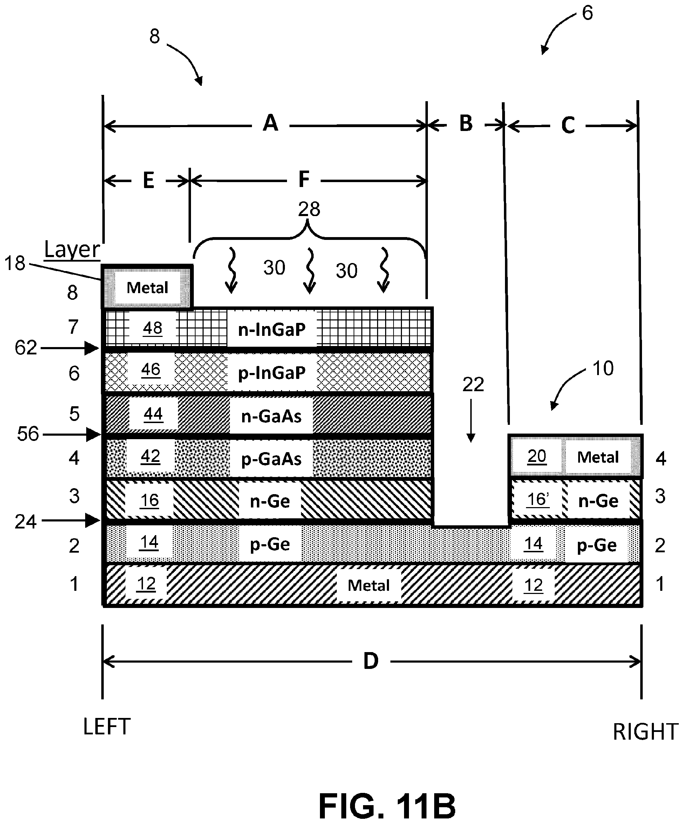

FIG. 11B shows a schematic elevation cross-section view of a triple-junction, integrated PV assembly 6 comprising a photovoltaic solar cell 8 with an integrated, monolithic blocking diode 10, using specific material selections, according to the present disclosure. This example is identical to FIG. 11A, except for the following differences. The first layer 12 comprises a metal or metal alloy. The second layer 14 comprises p-Ge. The third layers 16 and 16' comprise n-Ge. The fourth layer 42 comprises p-GaAs. The fifth layer 44 comprises n-GaAs. The sixth layer 46 comprises p-InGaP. The seventh layer 48 comprises n-InGaP. The right-side segments of the GaAs solar cell layers 44' and 42', and the InGaP layers 46' and 48' of blocking diode 10 have all been removed (e.g., by etching). The turn-on voltage of blocking diode 10 is approximately = 0.2 V.

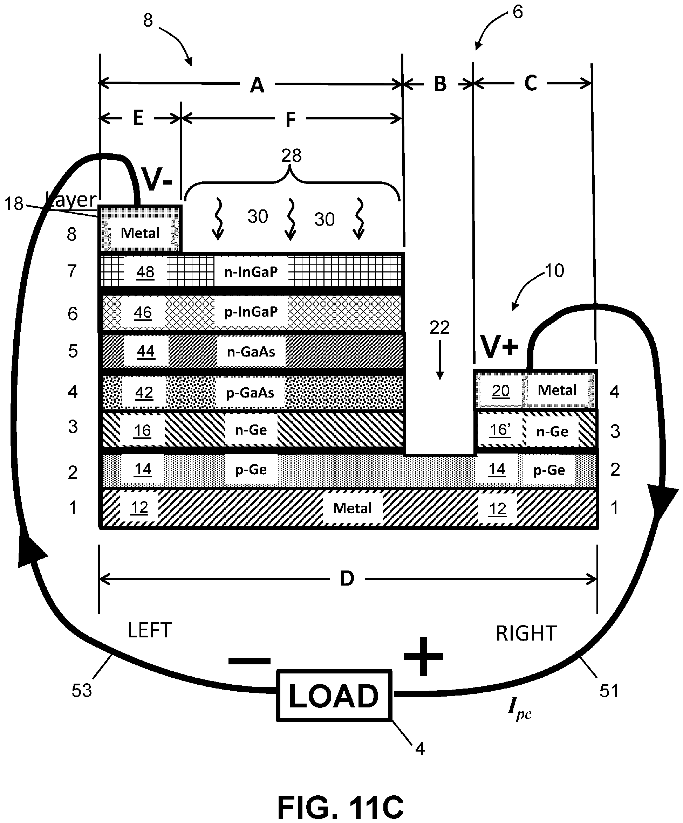

FIG. 11C shows a schematic elevation cross-section view of an example of a triple-junction, PV assembly 6 comprising a PV solar cell 8 with an integrated, monolithic blocking diode 10, wherein PV assembly 6 is electrically connected to a load 4, according to the present disclosure. This example is identical to FIG. 11B, except for the following additions. Electrical interconnects (e.g., wires and/or ribbons) 53 and 51 are connected to the first and second metal contacts 18 and 20, respectively, at one end, and connected to load 4 at their other end. First metal contact 18 has a voltage = **V-** and second metal contact 20 has a voltage = V+. Photo current ***I_{pc}*** travels through the PV solar cell 8 from top to bottom (or n-to-p). Then, photo current ***I_{pc}*** travels from bottom to top (or p-to-n) in blocking diode 10. Finally, photocurrent ***I_{pc}*** flows through load 4.

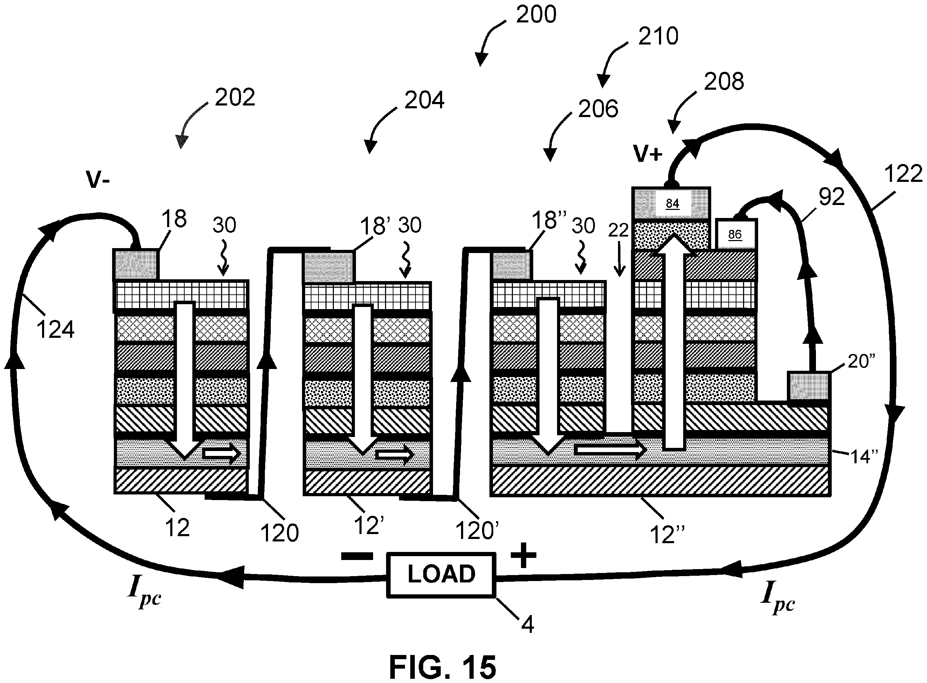

FIG. 12A shows a schematic elevation cross-section view of an example of a triple-junction, integrated, PV assembly 6 comprising a triple-junction, PV solar cell 8 with an integrated, monolithic blocking diode 10, according to the present disclosure. This example is identical to FIG. 15A, except for the following differences. First vertical trench 22 extends into a top surface of second layer 14. The right-side segments (i.e., stack 33) of layers 42', 44', 46', and 48' of blocking diode 10 have been removed (e.g., by etching). Second metal contact 20 is disposed on p-doped second layer 14, thereby forming a Schottky-type blocking diode 68. The integrated, monolithic blocking diode 10 comprises three stacked layers (from top to bottom), comprising: (a) the second metal contact 20, which is disposed on (b) the second layer 14, and which is disposed on (c) the first layer 12. Blocking diode 10 comprises Schottky-type diode 68.

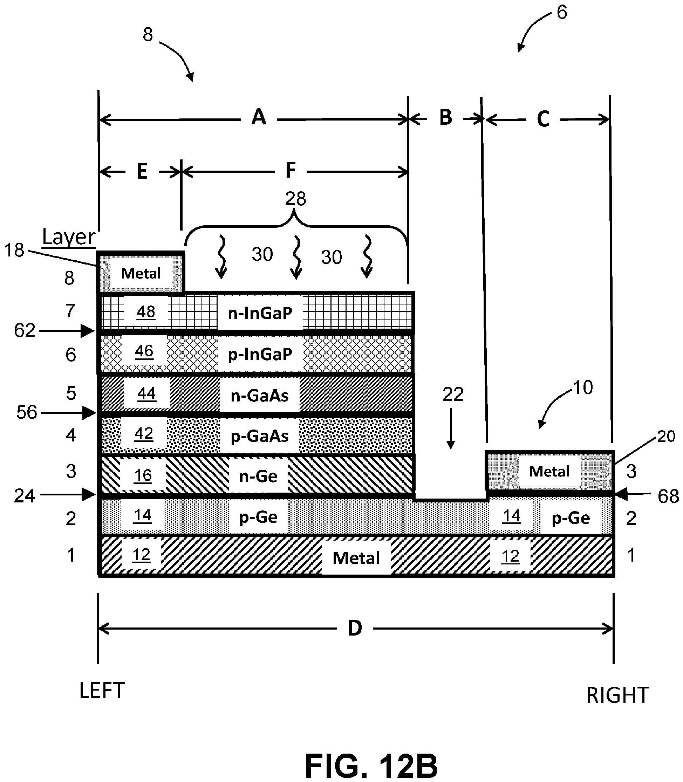

FIG. 12B shows a schematic elevation cross-section view of an example of a triple-junction, integrated PV assembly 6 comprising a photovoltaic solar cell 8 with an integrated, monolithic blocking diode 10, using specific material selections, according to the present disclosure. This example is identical to FIG. 12A, except for the following differences. The first layer 12 comprises a metal or metal alloy. The second layer 14 comprises p-Ge. The fourth layer 42 comprises p-GaAs. The fifth layer 44 comprises n-GaAs. The sixth layer 46 comprises p-InGaP. The seventh layer 48 comprises n-InGaP. The turn-on voltage of this Schottky blocking diode 10 is approximately = 0.2 V.

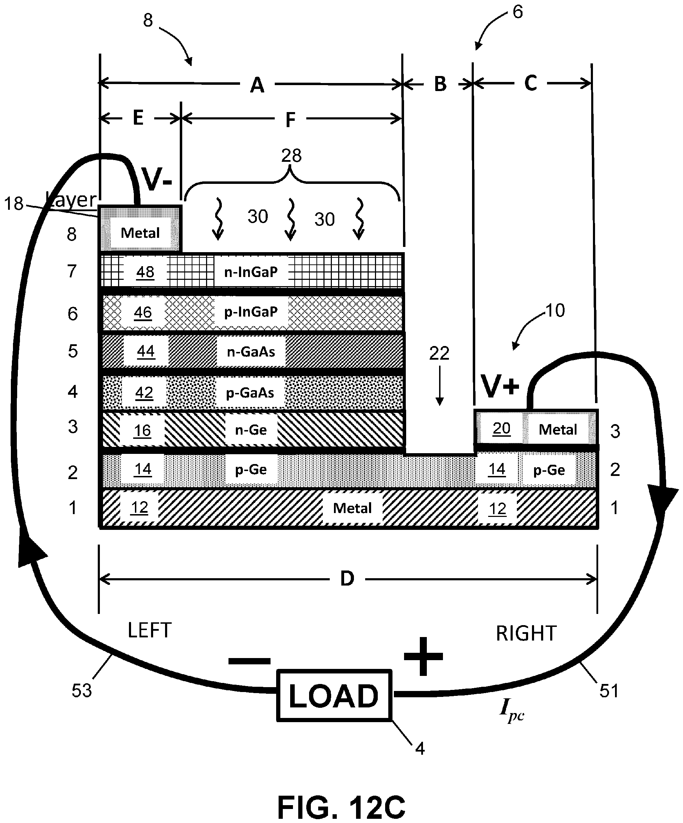

FIG. 12C shows a schematic elevation cross-section view of an example of a triple-junction, PV assembly 6 comprising a PV solar cell 8 with an integrated, monolithic blocking diode 10, wherein PV assembly 6 is electrically connected to a load 4, according to the present disclosure. This example is identical to FIG. 12B, except for the following additions. Electrical interconnects (e.g., wires and/or ribbons) 53 and 51 are connected to the first and second metal contacts 18 and 20, respectively, at one end, and connected to load 4 at their other end. First metal contact 18 has a voltage = **V-** and second metal contact 20 has a voltage = V+. Photo current ***I_{pc}*** travels through the PV solar cell 8 from top to bottom (or n-to-p). Then, photo current ***I_{pc}*** travels from bottom to top (or p-to-n) in blocking diode 10. Finally, photocurrent ***I_{pc}*** flows through load 4.

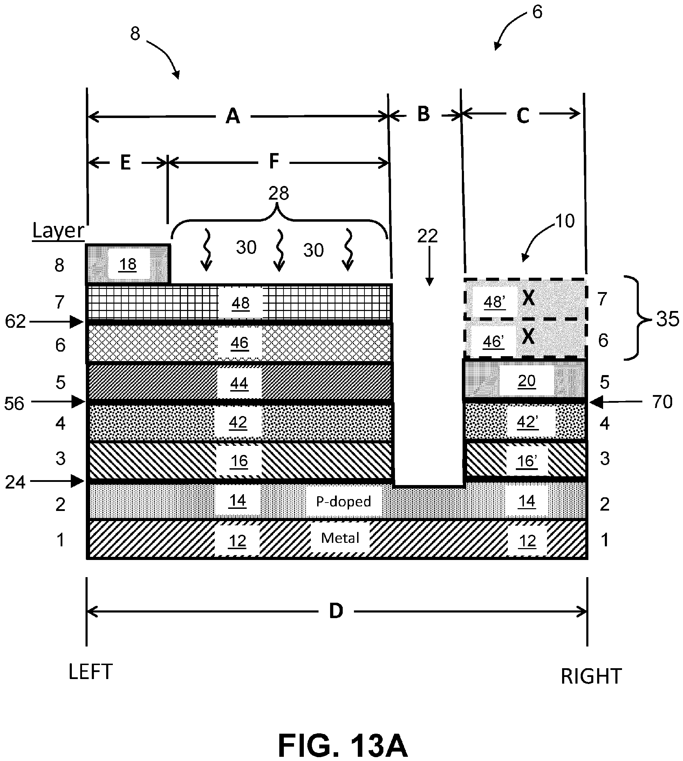

FIG. 13A shows a schematic elevation cross-section view of an example of a triple-junction, integrated, PV assembly 6 comprising a triple-junction, PV solar cell 8 with an integrated, monolithic blocking diode 10, according to the present disclosure. This example is identical to FIG. 10A, except for the following differences. First vertical trench 22 extends into a top surface of second layer 14. The right-side segments (i.e., stack 35) of layers 46' and 48' of blocking diode 10 have been removed (e.g., by etching). Second metal contact 20 is disposed above the fourth layer 42, thereby producing a Schottky-type diode 70. The integrated, monolithic blocking diode 10 comprises five stacked layers (from top to bottom), comprising: (a) the second metal contact 20, which is disposed on (b) the fourth layer 42, which is disposed on (c) the right-side segment 16' of third layer 16, which is disposed on (d) the second layer 14, and which is disposed on (e) the first layer 12. Blocking diode 10 comprises two stacked PN junctions, 27 and 70, respectively. The upper PN junction 70 is a Schottky-type diode junction.

FIG. 13B shows a schematic elevation cross-section view of a triple-junction, integrated PV assembly 6 comprising a photovoltaic solar cell 8 with an integrated, monolithic blocking diode 10, using specific material selections, according to the present disclosure. This example is identical to FIG. 13A, except for the following differences. The first layer 12 comprises a metal or metal alloy. The second layer 14 comprises p-Ge. The third layers 16 and 16' comprise n-Ge, and the fourth layers 42 and 42' comprise p-GaAs. The fifth layer 44 comprises n-GaAs. The sixth layer 46 comprises p-InGaP. The seventh layer 48 comprises n-InGaP. The turn-on voltage of blocking diode 10 is approximately = 2 V.

FIG. 13C shows a schematic elevation cross-section view of an example of a triple-junction, PV assembly 6 comprising a PV solar cell 8 with an integrated, monolithic blocking diode 10, wherein PV assembly 6 is electrically connected to a Load 4, according to the present disclosure. This example is identical to FIG. 13B, except for the following additions. Electrical interconnects (e.g., wires and/or ribbons) 53 and 51 are connected to the first and second metal contacts 18 and 20, respectively, at one end, and connected to Load 4 at their other end. First metal contact 18 has a voltage = **V-** and second metal contact 20 has a voltage = V+. Photo **current *I_{pc}*** travels through the PV solar cell 8 from top to bottom (or n-to-p). Then, photo current ***I_{pc}*** travels from bottom to top (or p-to-n) in blocking diode 10. Finally, photocurrent ***I_{pc}*** flows through load 4.

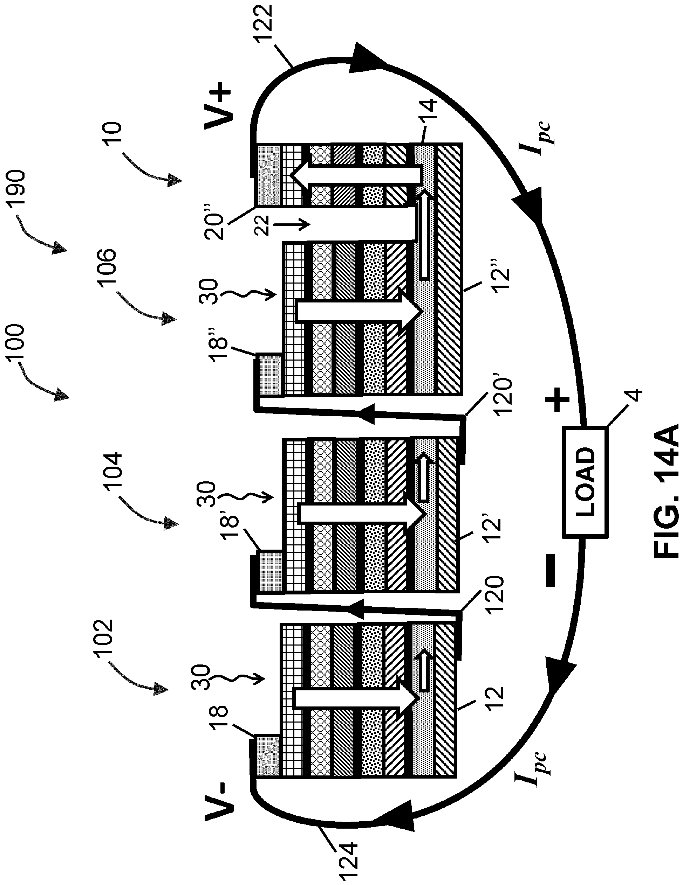

FIG. 14A shows a schematic cross-section view of an example of an electrical circuit 190 comprising an PV assembly 100 comprising a plurality of PV solar cells 102, 104, and 106, etc., connected in series to a Load 4, with a single, integrated, monolithic blocking diode 10 that is integrated with PV solar cell 106, according to the present disclosure. In this example, PV assembly 100 comprises three PV solar cells 102, 104, 106, which are triple-junction cells. The third PV solar cell 106 above the right-side (V+ end) has an additional vertical semiconductor stack that forms blocking diode 10. First vertical trench 22 separates PV solar cell 106 from blocking diode 10. Blocking diode 10 is constructed out of the same layers as triple-junction PV solar cell 106. Incident light 30 (e.g., sunlight) irradiates a respective active area 28 of each PV solar cell 102, 104, and 106. Photo current, ***I_{pc}**,* flows through each PV solar cell from top to bottom (i.e., from n-to-p). The photo current, ***I_{pc}**,* from each PV solar cell then flows horizontally through the p-doped second layer 14 and subsequently flows through first layer 12 and then from electrical connectors 120 and 120' to the next PV solar cell in sequence. Finally, photo current, ***I_{pc}**,* flows upwards through blocking diode 10 to reach second metal contact 20. The photo current, ***I_{pc}**,* in blocking diode 10 travels from bottom to top (i.e., from p-to-n). Assembly 100 uses the same materials and semiconductor fabrication processes as the PV solar cell 106 to form the blocking diode 10. PV solar cell 106 and blocking diode 10 both share a first layer 12 and a common second layer 14. Photo current ***I_{pc}** ,* then flows from second metal contact 20 to load 4 via first connector 122; and, finally, from load 4 back to first metal contact 18 via second connector 124.

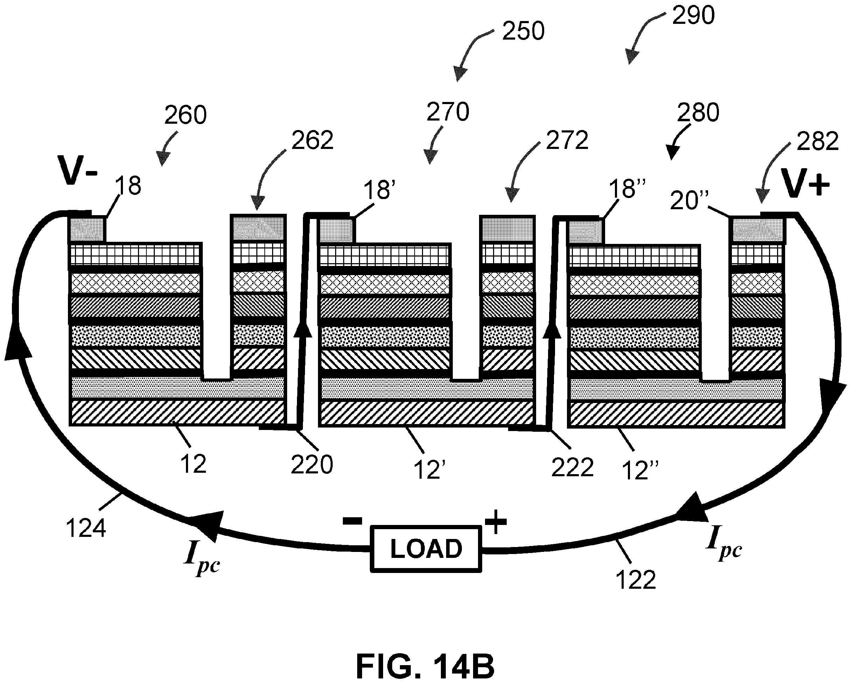

FIG. 14B shows a schematic cross-section view of an example of an electrical circuit 290 comprising an PV assembly 250 comprising a plurality of PV solar cells 260, 270, 280, etc., connected in series to a Load 4, wherein each PV solar cell 260, 270, 280, etc. comprises their own individual, integrated, monolithic blocking diode 262, 272, and 282, respectively, according to the present disclosure. In this example, PV assembly 250 comprises three, triple-junction PV solar cells 260, 270, 280 connected in series.

FIG. 15 shows a schematic cross-section view of an example of an electrical circuit 210 comprising an PV assembly 200 comprising a plurality of PV solar cells 202, 204, 206, etc. connected in series to a Load 4, with a single, integrated, monolithic blocking diode 208, according to the present disclosure. The third PV solar cell 206 above the right-side (V+ end) has an additional vertical semiconductor stack 208 that forms blocking diode 208. First vertical trench 22 separates PV solar cell 206 from blocking diode 208. Blocking diode 208 is constructed out of the same materials used for triple-junction PV solar cell 206, but with a different layered structure. Incident light 30 (e.g., sunlight) irradiates a respective active area 28 of each PV solar cell 202, 204, and 206. Photo current, ***I_{pc}**,* then flows through each PV solar cell from top to bottom (i.e., from n-to-p). The photo current, ***I_{pc}** ,* from each PV solar cell then flows horizontally through the p-doped second layer 14, then through first layer 12, and subsequently flows through electrical connectors 120 and 120' to the next PV solar cell in sequence. Finally, photo current ***I_{pc}*** flows upwards through blocking diode 208 to reach third metal contact 84.

Referring still to FIG 15, the current ***I_{pc}*** from the solar cells flowing in blocking diode 208 normally travels from bottom to top (i.e., from p-to-n). Photocurrent ***I_{pc}*** then flows from third metal contact 84 to load 4 via first connector 122; and finally from load 4 back to first metal contact 18 via second connector 124. Metal connection 92 electrically interconnects second metal contact 20 to fourth metal contact 86. When the third PV solar cell 206 is shadowed, blocking diode 208 is blocked (due to being reverse biased). In this condition, photo current ***I_{pc}*** then flows from second metal contact 20, through metal shunt 92, to fourth metal contact 86, then to third metal contact 84, then to load 4, and finally back to first metal contact 18. PV assembly 200 uses the same materials and semiconductor fabrication processes as the PV solar cell 206 to form blocking diode 208. PV solar cell 206 and blocking diode 208 both share a first layer 12 and a common second layer 14.

In general, the blocking diode 10 should be constructed as to eliminate as much as possible generation of photocurrent, which can be prevented by completely covering the top surface of the blocking diode 10 with opaque metal to prevent sunlight 30 from irradiating the blocking diode 10.

In some examples, PV solar cell 8 comprises the same layers as blocking diode 10.

In some examples, PV solar cell 8 comprises different layers than blocking diode 10.

In some examples, PV solar cell 8 comprises fewer layers than blocking diode 10.

In some examples, PV solar cell 8 comprises more layers than blocking diode 10.

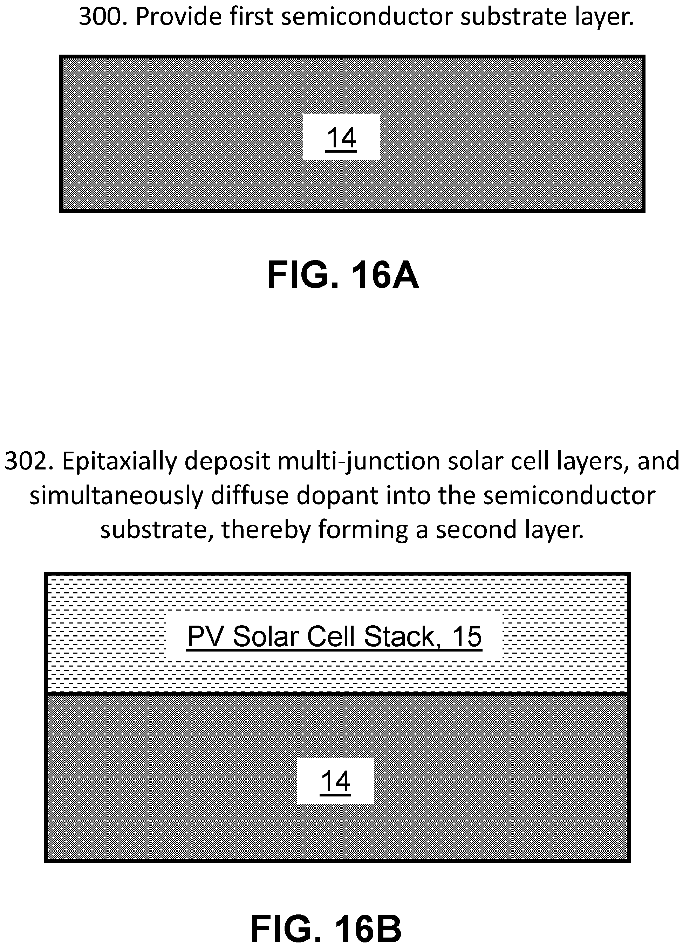

FIG. 16A shows a schematic elevation cross-section view of an example of a first step of fabricating a multi-junction, photovoltaic solar cell with an integrated, monolithic blocking diode, according to the present disclosure. The first fabrication step comprises providing a p-doped first semiconductor substrate layer 14, which can comprise p-doped germanium.

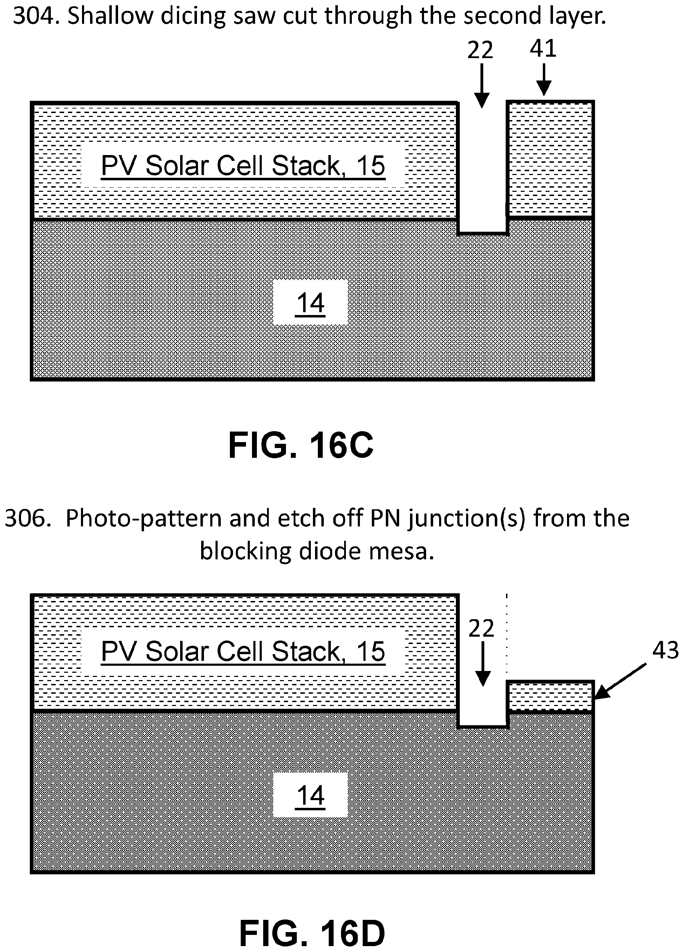

FIG. 16B shows a schematic elevation cross-section view of an example of a second step of fabricating a multi-junction, photovoltaic solar cell with an integrated, monolithic blocking diode, according to the present disclosure. The second fabrication step comprises epitaxially depositing a plurality of multijunction solar cell layers 15, and simultaneously diffusing an n-dopant into the p-doped first semiconductor substrate layer 14, thereby forming a p-doped second semiconductor layer 16 on top of the p-doped first semiconductor substrate layer 14. The PV solar cell stack 15 may consist of a single solar cell 8 or multiple solar cells 8 stacked vertically. In some examples, second layer 14 can comprise p-doped germanium. Note that, in some examples, the thickness of the multi-junction solar cell layers 15 can be approximately 1% of the thickness of the p-doped first semiconductor substrate layer 14.FIG. 16C shows a schematic elevation cross-section view of an example of a third step of fabricating a multi-junction, photovoltaic solar cell with an integrated, monolithic blocking diode, according to the present disclosure. The third fabrication step comprises shallow dicing saw cutting a trench 22 through multi-junction solar cell layers 15 and partially into the n-doped second semiconductor layer 16 to isolate a blocking diode mesa 41.

Alternatively, photopatterning and etching could be used to define blocking diode mesa 41.

FIG. 16D shows a schematic elevation cross-section view of an example of a fourth step of fabricating a multi-junction photovoltaic solar cell with an integrated, monolithic blocking diode, according to the present disclosure. The fourth fabrication step comprises photo-patterning and etching off one or more PN diode junction(s) from the blocking diode mesa 41 to form an integrated, monolithic blocking diode 43. The complete PN diode (with an associated tunnel junction) can be removed in this step.

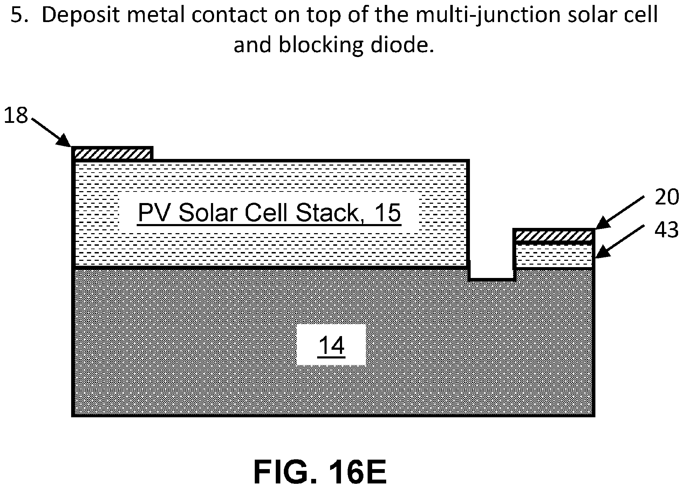

FIG. 16E shows a schematic elevation cross-section view of an example of a fifth step of fabricating a multi-junction, photovoltaic solar cell with an integrated, monolithic blocking diode, according to the present disclosure. The fifth fabrication step comprises forming a pair of metal contacts, for example first and second metal contacts 18 and 20, respectively, by photo-patterning and lifting-off of evaporated first and second metal contacts 18 and 20, respectively, above the top of the multi-junction solar cell 15 and blocking diode 43, respectively.

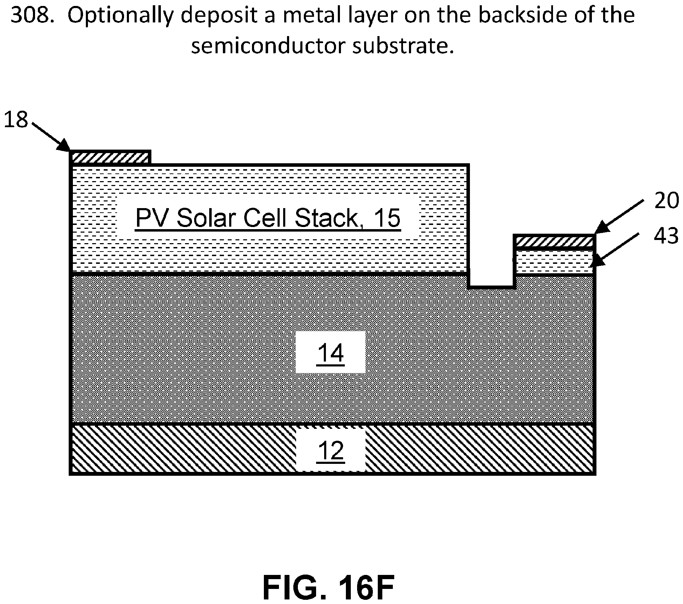

FIG. 16F shows a schematic elevation cross-section view of an example of a sixth step of fabricating a multi-junction, photovoltaic solar cell with an integrated, monolithic blocking diode, according to the present disclosure. The sixth and final fabrication step optionally comprises depositing a metal layer 12 on a backside of the p-doped first semiconductor substrate layer 14.

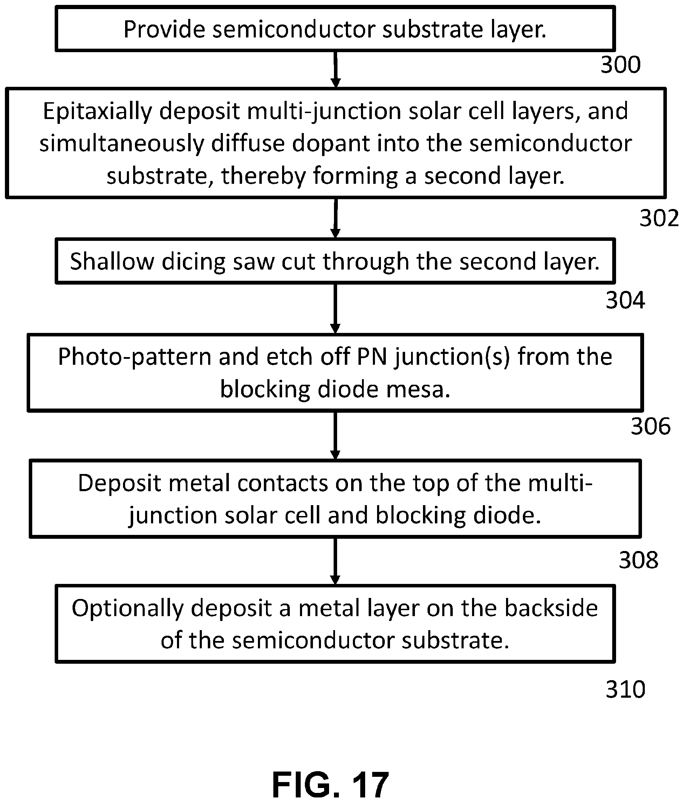

FIG. 17 shows a process flow chart illustrating an example of process steps for fabricating a PV solar cell 8 with an integrated, monolithic blocking diode 10 by using semiconductor processes, according to the present disclosure. Step 300 comprises providing a p-doped first semiconductor substrate layer 14, which can comprise p-doped germanium. Next, step 302 comprises epitaxially depositing a plurality of multi-junction solar cell layers 15, and simultaneously diffusing an n-dopant into the p-doped first semiconductor substrate layer 14, thereby forming a p-doped second semiconductor layer 16 on top of the p-doped first semiconductor substrate layer 14. Next, step 304 comprises shallow dicing saw cutting a trench 22 through multi-junction solar cell layers 15 and partially into the n-doped second semiconductor layer 16 to isolate a blocking diode mesa 19. Next, step 306 comprises photo-patterning and etching off one or more PN junction(s) from the blocking diode mesa 19 to form a blocking diode 17. The complete PN diode, with its associated tunnel junction, must be removed in this step. Next, step 308 comprises depositing (for example, by photo-patterning and lifting-off) a pair of metal contacts, such as first and second metal contacts 18 and 20 on top of the multi-junction solar cell 15 and blocking diode 17, respectively. Finally, step 310 optionally comprises depositing a metal layer 12 on a backside of the p-doped first semiconductor substrate layer 14.

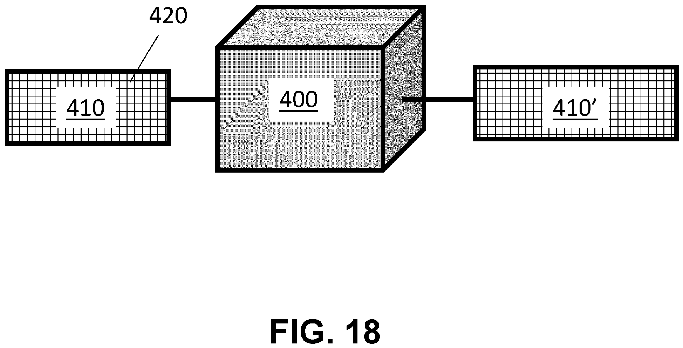

FIG. 18 shows a schematic perspective view of an example of an extraterrestrial satellite 400 with a pair of PV solar panels 410, 410' that are attached to satellite 400, wherein each PV solar panel 410, 410' comprises a triple-junction, PV solar cell 420 with an integrated, monolithic blocking diode (that is too small to be seen), according to the present disclosure. PV solar cell 420 is fabricated using the same configurations and semiconductor process disclosed herein.

Further, the disclosure comprises examples according to the following clauses:
Clause 1. A multi-junction, photovoltaic (PV) solar cell with an integrated, monolithic blocking diode, comprising: a first layer, having a width = D, comprising a conductive metal; a second layer, having a width = D, disposed above the first layer, and comprising a p-doped first semiconductor material; a PV solar cell stack, having a width= A, disposed above the second layer; a blocking diode stack, having a width = C, disposed above the second layer; a first vertical trench, having a width = B, extending down into the second layer and located in between the PV solar cell stack and the integrated, monolithic blocking diode stack; a first metal contact, having a width = E, disposed on a portion of a top surface of the PV solar cell stack; and a second metal contact, having a width = C, disposed completely across a top surface of the blocking diode stack; wherein the PV solar cell stack comprises an active solar width, having a width = F; wherein the PV solar cell stack and the integrated, monolithic blocking diode stack are both disposed above the second layer; and wherein E < A, E < F, F < A,B < C, B < A, A < D, C < D, A = E + F and D = A + B + C.
Clause 2. The PV solar cell of Clause 1, wherein the first semiconductor material comprises germanium.
Clause 3. The PV solar cell of Clause 1 or 2, wherein the PV solar cell stack comprises a same number of layers as the integrated, monolithic blocking diode stack.
Clause 4. The PV solar cell of any of Clauses 1-3, wherein the PV solar cell stack comprises fewer layers than the integrated, monolithic blocking diode stack.
Clause 5. The PV solar cell of any of Clauses 1-3, wherein the PV solar cell stack comprises more layers than the integrated, monolithic blocking diode stack.
Clause 6. The PV solar cell of any of Clauses 1-5, wherein the second metal contact is disposed directly above the second layer, thereby forming a Schottky diode.
Clause 7. The PV solar cell of any of Clauses 1-6, further comprising a third layer, having a width = A, disposed above the second layer, wherein the third layer comprises an n-doped first semiconductor material.
Clause 8. The PV solar cell of Clause 7, wherein the second metal contact is disposed directly above the third layer, thereby forming a Schottky diode.
Clause 9. The PV solar cell of Clause 7 or 8, further comprising: a fourth layer, having a width = A, disposed above the third layer, wherein the fourth layer comprises a p-doped second semiconductor material; and a fifth layer, having a width = A, disposed above the fourth layer, wherein the fifth layer comprises a n-doped second semiconductor material.
Clause 10. The PV solar cell of Clause 9, further comprising: a sixth layer, having a width = A, disposed above the fifth layer, wherein the sixth layer comprises a p-doped third semiconductor material; and a seventh layer, having a width = A, disposed above the sixth layer, wherein the seventh layer comprises an n-doped third semiconductor material; wherein the first semiconductor material comprises germanium; wherein the second semiconductor material comprises GaAs; and wherein the third semiconductor material comprises InGaP.
Clause 11. A triple-junction, photovoltaic (PV) solar cell with an integrated, monolithic blocking diode, comprising: a first layer, having a width = F, comprising a conductive metal; a second layer, having a width = F, comprising a p-doped first semiconductor material disposed above the first layer; a triple-junction PV solar cell stack, having a width= A, comprising: a third layer, having a width = A, comprising an n-doped first semiconductor material disposed above the second layer; a fourth layer, having a width = A, comprising an p-doped second semiconductor material disposed above the third layer; a fifth layer, having a width = A, comprising an n-doped second semiconductor material disposed above the fourth layer; a sixth layer, having a width = A, comprising a p-doped third semiconductor material disposed above the fifth layer; a seventh layer, having a width = A, comprising an n-doped third semiconductor material disposed above the sixth layer; wherein the triplejunction PV solar cell stack is disposed above the second layer; and further comprising: an integrated, monolithic blocking diode stack, having a width = C, disposed above the second layer comprising: a third layer, having a width = C, comprising an n-doped first semiconductor material disposed above the second layer; a fourth layer, having a width = C, comprising an p-doped second semiconductor material disposed above the third layer; a fifth layer, having a width = C, comprising an n-doped second semiconductor material disposed above the fourth layer; a sixth layer, having a width = C, comprising a p-doped third semiconductor material disposed above the fifth layer; a seventh layer, having a width = C, comprising an n-doped third semiconductor material disposed above the sixth layer; an eighth layer, having a width = C, comprising an n-doped second semiconductor material disposed above the seventh layer; and a ninth layer, having a width = I, comprising an p-doped second semiconductor material disposed above a portion of the eighth layer; a first trench, having a width = B, extending down into the second layer, wherein the first trench is disposed in between the triple-junction PV solar cell stack and the integrated, monolithic blocking diode stack; a first metal contact, having a width = G, disposed above a portion of a top surface of the seventh layer; and a second metal contact, having a width = E, disposed above the third layer; a third metal contact, having a width = I, disposed above and completely across the ninth layer; a fourth metal contact, having a width = K, disposed above a portion of the eighth layer; a second trench, having a width = J, extending down into the eighth layer, and disposed in between the ninth layer and the fourth metal contact; a third trench, having a width = D, extending down into the third layer, and disposed in between the integrated, monolithic blocking diode stack and the second metal contact; a first conductor electrically connecting the second metal contact to the fourth metal contact; wherein the triple-junction PV solar cell stack comprises an active solar width having a width = H; wherein the triple-junction PV solar cell stack and the integrated, monolithic blocking diode stack are both disposed above the second layer; wherein A < F, D < C, B < A, B < C, G < A, I < C, K < C, J < C, G < H, H < A; A = G + H, C = I + J + K, and F = A + B + C + D + E.
Clause 12. The PV solar cell of Clause 11, wherein the first semiconductor material comprises Ge; wherein the second semiconductor material comprises GaAs; and wherein the third semiconductor material comprises InGaP.
Clause 13. The PV solar cell of Clause 11 or 12, wherein the first conductor comprises an integrated, monolithic metal shunt.
Clause 14. The PV solar cell of any of Clauses 11-13, wherein the PV solar cell is configured to attach to a PV solar panel of an extraterrestrial satellite.
Clause 15. The PV solar cell of any of Clauses 11-14, further comprising: a second electrical connector connecting the first metal contact to a negative side of a load, and a third electrical connector connecting the second metal contact to a positive side of the load.
Clause 16. A photovoltaic (PV) assembly, comprising: a string of three, identical, separated PV solar cells, comprising a first PV solar cell, a second PV solar cell, and a third PV solar cell, all electrically connected in series; wherein each PV solar cell comprises: a first layer comprising metal; a second layer comprising a p-doped first semiconductor material; a PV solar cell stack, having a first number of doped semiconductor layers, disposed above the second layer; a trench extending down into the second layer, defining an integrated, monolithic blocking diode stack, disposed above the second layer, which has a second number of doped semiconductor layers; a first metal contact disposed on a portion of a top of the PV solar cell stack; and a second metal contact disposed completely across a top of the integrated, monolithic blocking diode stack; wherein the PV assembly further comprises: a first electrical conductor connecting a first layer of the first PV solar cell to a first metal contact of the second PV solar cell, which is disposed adjacent to the first PV solar cell; a second electrical conductor connecting a first layer of the second PV solar cell to a first metal contact of the third PV solar cell, which is disposed adjacent to the second PV solar cell; a third electrical conductor connecting a first metal contact of the first PV solar cell to a negative side of a load; and a fourth electrical conductor connecting a second metal contact of the third PV solar cell to a positive side of the load.
Clause 17. The PV assembly of Clause 16, wherein the second number of doped semiconductor layers is less than the first number of doped semiconductor layers.
Clause 18. A photovoltaic (PV) assembly, comprising: a string of three, separated triple-junction PV solar cells, comprising a first PV solar cell, a second PV solar cell, and a third PV solar cell, all electrically connected in series; wherein the first and second triple-junction PV solar cells are identical and each one comprises: a first layer of the first or second PV solar cell comprising metal; a second layer of the first or second PV solar cell comprising a p-doped first semiconductor material; a triple-junction PV solar cell stack of the first or second PV solar cell, comprising a first number of doped semiconductor layers, disposed above the second layer; and a first metal contact of the first or second PV solar cell disposed on a portion of a top of the triple junction PV solar cell stack; wherein the third PV solar cell comprises a triple-junction PV solar cell stack and an integrated, monolithic blocking diode stack; wherein the PV solar cell stack of the third PV solar cell comprises: a first layer of the third PV solar cell comprising metal; and a second layer of the third PV solar cell comprising a p-doped first semiconductor material, disposed above the first layer of the third PV solar cell; a third layer of the third PV solar cell comprising an n-doped first semiconductor material disposed above the second layer of the third PV solar cell; a fourth layer of the third PV solar cell comprising an p-doped second semiconductor material disposed above the third layer of the third PV solar cell; a fifth layer of the third PV solar cell comprising an n-doped second semiconductor material disposed above the fourth layer of the third PV solar cell; a sixth layer of the third PV solar cell comprising a p-doped third semiconductor material disposed above the fifth layer of the third PV solar cell; and a seventh layer of the third PV solar cell comprising an n-doped third semiconductor material disposed above the sixth layer of the third PV solar cell; wherein the PV solar cell stack of the third PV solar cell is disposed above the second layer of the third PV solar cell; wherein the third PV solar cell further comprises an integrated, monolithic blocking diode stack disposed above the second layer of the third PV solar cell; and wherein the integrated, monolithic blocking diode stack of the third PV solar cell comprises: the third layer of the third PV solar cell disposed above the second layer of the third PV solar cell; the fourth layer of the third PV solar cell disposed above the third layer of the third PV solar cell; the fifth layer of the third PV solar cell disposed above the fourth layer of the third PV solar cell; the sixth layer of the third PV solar cell disposed above the fifth layer of the third PV solar cell; the seventh layer of the third PV solar cell disposed above the sixth layer of the third PV solar cell; an eighth layer of the third PV solar cell comprising an n-doped second semiconductor material disposed above the seventh layer of the third PV solar cell; and a ninth layer of the third PV solar cell comprising an p-doped second semiconductor material disposed above a portion of the eighth layer of the third PV solar cell; a first trench of the third PV solar cell extending down into the second layer of the third PV solar cell, wherein the first trench of the third PV solar cell is disposed in between the PV solar cell stack of the third PV solar cell and the blocking diode; a first metal contact of the third PV solar cell disposed above a portion of a top surface of the seventh layer of the third PV solar cell; and a second metal contact of the third PV solar cell disposed above the second layer of the third PV solar cell; a third metal contact of the third PV solar cell disposed above, and completely across, the ninth layer of the third PV solar cell; a fourth metal contact of the third PV solar cell disposed above a portion of the eighth layer of the third PV solar cell; a second trench of the third PV solar cell extending down into the eighth layer of the third PV solar cell, and disposed in between the ninth layer of the third PV solar cell and the fourth metal contact of the third PV solar cell; a third trench of the third PV solar cell extending down into the third layer of the third PV solar cell, and disposed in between the integrated, monolithic blocking diode stack and the second metal contact of the third PV solar cell; and wherein the PV assembly further comprises: a first electrical conductor connecting a second metal contact of the third PV solar cell to a fourth metal contact of the third PV solar cell; a second electrical conductor connecting a first layer of the first PV solar cell to a first metal contact of the second PV solar cell; a third electrical conductor connecting a first layer of the second PV solar cell to a first metal contact of the third PV solar cell; a fourth electrical conductor connecting a first metal contact of the first PV solar cell to a negative side of a load; and a fifth electrical conductor connecting a third metal contact of the third PV solar cell to a positive side of the load; wherein the first PV solar cell is disposed adjacent to the second PV solar cell; and wherein the second PV solar cell is disposed adjacent to the third PV solar cell;
Clause 19. The PV assembly of Clause 18, wherein the second metal contact of the third PV solar cell is disposed above the third layer of the third PV solar cell.
Clause 20. The PV assembly of Clause 18 or 19, wherein the first semiconductor material comprises Ge; wherein the first semiconductor material comprises GaAs; and wherein the first semiconductor material comprises InGaP.
Clause 21. A method of fabricating a Photovoltaic (PV) solar cell with an integrated, monolithic blocking diode, comprising:
   (a) providing a p-doped first semiconductor substrate layer;
   (b) epitaxially depositing a plurality of multijunction solar cell layers, and simultaneously diffusing an n-dopant into the p-doped first semiconductor substrate layer, thereby forming a p-doped second semiconductor layer on top of the p-doped first semiconductor substrate layer;
   (c) shallow dicing saw cutting a trench through multi-junction solar cell layers and partially into the n-doped second semiconductor layer, thereby isolating a blocking diode mesa;
   (d) photo-patterning and etching off one or more PN junction(s) from the blocking diode mesa to form a blocking diode;
   (e) depositing a first metal contact on top of the multi-junction solar cell; and
   (f) depositing a second metal contact on top of the blocking diode.
Clause 22. The method of clause 21, further comprising depositing a metal layer on a backside of the p-doped first semiconductor substrate layer.

In the current disclosure, reference is made to various aspects. However, it should be understood that the present disclosure is not limited to specific described aspects. Instead, any combination of the features and elements, whether related to different aspects or not, is contemplated to implement and practice the teachings provided herein. Additionally, when elements of the aspects are described in the form of "at least one of A and B," it will be understood that aspects including element A exclusively, including element B exclusively, and including element A and B are each contemplated. Furthermore, although some aspects can achieve advantages over other possible solutions and/or over the prior art, whether or not a particular advantage is achieved by a given aspect is not limiting of the present disclosure. Thus, the aspects, features, aspects and advantages disclosed herein are merely illustrative and are not considered elements or limitations of the appended claims except where explicitly recited in a claim(s). Likewise, reference to "the invention" shall not be construed as a generalization of any inventive subject matter disclosed herein and shall not be considered to be an element or limitation of the appended claims except where explicitly recited in a claim(s).

Unless otherwise indicated, the terms "first," "second," etc. are used herein merely as labels, and are not intended to impose ordinal, positional, or hierarchical requirements on the items to which these terms refer. Moreover, reference to, for example, a "second" item does not require or preclude the existence of, for example, a "first" or lower-numbered item or a "third" or higher-numbered item.

Spatially relative terms, such as "beneath," "below," "lower," "above," "upper," and the like may be used herein for ease of description to describe the relationship of one component and/or feature to another component and/or feature, or other component(s) and/or feature(s), as illustrated in the drawings. It will be understood that the spatially relative terms are intended to encompass different orientations of the device in use or operation in addition to the orientation(s) depicted in the figures.

The terms "comprising", "comprise" and "comprises" herein are intended to be optionally substitutable with the terms "consisting essentially of", "consist essentially of", "consists essentially of", "consisting of", "consist of" and "consists of", respectively, in every instance. To the extent that terms "includes," "including," "has," "contains," and variants thereof are used herein, such terms are intended to be inclusive in a manner similar to the term "comprises" as an open transition word without precluding any additional or other elements.

## Claims

1. A photovoltaic (PV) solar cell (8) with an integrated, monolithic blocking diode (10), comprising:
a first layer (12), having a width = D, comprising a conductive metal;
a second layer (14), having a width = D, disposed above the first layer (12), and comprising a p-doped first semiconductor material;
a PV solar cell stack (15), having a width= A, disposed above the second layer (12);
a blocking diode stack (17), having a width = C, disposed above the second layer (12);
a first vertical trench (22), having a width = B, extending down into the second layer (12) and located in between the PV solar cell stack (15) and the integrated, monolithic blocking diode stack (17);
a first metal contact (18), having a width = E, disposed on a portion of a top surface of the PV solar cell stack (15); and
a second metal contact (20), having a width = C, disposed completely across a top surface of the blocking diode stack (17);
wherein the PV solar cell stack (15) comprises an active solar width (28), having a width = F;
wherein the PV solar cell stack (15) and the integrated, monolithic blocking diode stack (17) are both disposed above the second layer; and
wherein E < A,E < F, F < A,B < C, B < A, A < D, C < D, A = E + F and D = A + B + C.

2. The PV solar cell (8) of claim 1, wherein the first semiconductor material comprises germanium.

3. The PV solar cell (8) of claim 1 or 2, wherein the PV solar cell stack (15) comprises: a same number of layers as, fewer layers than, or more layers than the integrated, monolithic blocking diode stack (17).

4. The PV solar cell (8) of any of claims 1 to 3, wherein the second metal contact (20) is disposed directly above the second layer (12), thereby forming a Schottky-type diode (26).

5. The PV solar cell (8) of any of claims 1 to 4, further comprising a third layer (16), having a width = A, disposed above the second layer (14), wherein the third layer (16) comprises an n-doped first semiconductor material, wherein the second metal contact (20) is preferably disposed directly above the third layer (16), thereby forming a Schottky-type diode (26).

6. The PV solar cell (8) of claim 5, further comprising:
a fourth layer (42), having a width = A, disposed above the third layer (16), wherein the fourth layer (42) comprises a p-doped second semiconductor material; and
a fifth layer (44), having a width = A, disposed above the fourth layer (42), wherein the fifth layer (44) comprises a n-doped second semiconductor material.

7. The PV solar cell (8) of claim 6, further comprising:
a sixth layer (46), having a width = A, disposed above the fifth layer (44), wherein the sixth layer (46) comprises a p-doped third semiconductor material; and
a seventh layer (48), having a width = A, disposed above the sixth layer (46), wherein the seventh layer (48) comprises an n-doped third semiconductor material;
wherein the first semiconductor material comprises germanium;
wherein the second semiconductor material comprises GaAs; and
wherein the third semiconductor material comprises InGaP.

8. A triple-junction, photovoltaic (PV) solar cell (8) with an integrated, monolithic blocking diode (10), comprising:
a first layer (12), having a width = F, comprising a conductive metal;
a second layer (14), having a width = F, comprising a p-doped first semiconductor material disposed above the first layer (12);
a triple junction PV solar cell stack (17), having a width = A, comprising:
a third layer (16), having a width = A, comprising an n-doped first semiconductor material disposed above the second layer (14);
a fourth layer (42), having a width = A, comprising an p-doped second semiconductor material disposed above the third layer (16);
a fifth layer (44), having a width = A, comprising an n-doped second semiconductor material disposed above the fourth layer (42);
a sixth layer (46), having a width = A, comprising a p-doped third semiconductor material disposed above the fifth layer (44);
a seventh layer (48), having a width = A, comprising an n-doped third semiconductor material disposed above the sixth layer (46);
wherein the triple-junction PV solar cell stack (15) is disposed above the second layer;
and further comprising:
an integrated, monolithic blocking diode stack (17), having a width = C, disposed above the second layer (14) comprising:
a third layer (16), having a width = C, comprising an n-doped first semiconductor material disposed above the second layer (14);
a fourth layer (42), having a width = C, comprising an p-doped second semiconductor material disposed above the third layer (16);
a fifth layer (44), having a width = C, comprising an n-doped second semiconductor material disposed above the fourth layer (42);
a sixth layer (46), having a width = C, comprising a p-doped third semiconductor material disposed above the fifth layer (44);
a seventh layer, having a width = C, comprising an n-doped third semiconductor material disposed above the sixth layer (46);
an eighth layer (80), having a width = C, comprising an n-doped second semiconductor material disposed above the seventh layer (48); and
a ninth layer (82), having a width = I, comprising an p-doped second semiconductor material disposed above a portion of the eighth layer (80);
a first trench (22), having a width = B, extending down into the second layer (14), wherein the first trench (22) is disposed in between the triple-junction PV solar cell stack (15) and the integrated, monolithic blocking diode stack (17);
a first metal contact (18), having a width = G, disposed above a portion of a top surface of the seventh layer (48); and
a second metal contact (20), having a width = E, disposed above the third layer (16);
a third metal contact (84), having a width = I, disposed above and completely across the ninth layer (82);
a fourth metal contact (86), having a width = K, disposed above a portion of the eighth layer (80);
a second trench (88), having a width = J, extending down into the eighth layer (80), and disposed in between the ninth layer (82) and the fourth metal contact (86);
a third trench (90), having a width = D, extending down into the third layer (16), and disposed in between the integrated, monolithic blocking diode stack (17) and the second metal contact (20);
a first conductor (92) electrically connecting the second metal contact (20) to the fourth metal contact (86);
wherein the triple-junction PV solar cell stack (17) comprises an active solar width (28) having a width = H;
wherein the triple-junction PV solar cell stack (15) and the integrated, monolithic blocking diode stack (17) are both disposed above the second layer (14); and
wherein A < F, D < C, B < A, B < C, G < A, I < C, K < C, J < C, G < H, H < A;
A=G+H,C=I+J+K,andF=A+B+C+D+E.

9. The PV solar cell (8) of claim 8,
wherein the first semiconductor material comprises Ge;
wherein the second semiconductor material comprises GaAs; and
wherein the third semiconductor material comprises InGaP.

10. The PV solar cell (8) of claim 8 or 9, wherein the first conductor (92) comprises an integrated, monolithic metal shunt (96).

11. The PV solar cell (8) of any of claims 8 to 10 , wherein the PV solar cell (8) is configured to attach to a PV solar panel (410) of an extraterrestrial satellite (400).

12. The PV solar cell (8) of any of claims 8 to 11, further comprising:
a second electrical connector (53) connecting the first metal contact (18) to a negative side of a load (4), and
a third electrical connector (51) connecting the second metal contact (20) to a positive side of the load (4).

13. A photovoltaic (PV) assembly (200), comprising:
a string (200) of three triple-junction PV solar cells (202, 204, and 206), comprising a first triple-junction PV solar cell (202), a second triple-junction PV solar cell (204), and a third triple-junction PV solar cell (206), all electrically connected in series;
wherein the first and second triple-junction PV solar cells (202 and 204) are identical and each one comprises:
a first layer (12) of the first or second PV solar cell (202 or 204) comprising metal;
a second layer (14) of the first or second PV solar cell (202 or 204) comprising a p-doped first semiconductor material;
a triple junction PV solar cell stack (15) of the first or second PV solar cell (202 or 204), comprising a first number of doped semiconductor layers, disposed above the second layer (12 or 12'); and
a first metal contact (18 or 18') of the first or second PV solar cell (202 or 204) disposed on a portion of a top of the triple junction PV solar cell stack (17 or 17');
wherein the third PV solar cell (206) comprises a triple-junction PV solar cell stack (15") and an integrated, monolithic blocking diode stack (17");
wherein the triple-junction PV solar cell stack (15") of the third PV solar cell comprises:
a first layer (12") comprising metal; and
a second layer (14") comprising a p-doped first semiconductor material, disposed above the first layer (12") of the third PV solar cell (206);
a third layer (16") comprising an n-doped first semiconductor material disposed above the second layer (14");
a fourth layer (42") comprising an p-doped second semiconductor material disposed above the third layer (16");
a fifth layer (44") comprising an n-doped second semiconductor material disposed above the fourth layer (42");
a sixth layer (46") comprising a p-doped third semiconductor material disposed above the fifth layer (44"); and
a seventh layer (48") comprising an n-doped third semiconductor material disposed above the sixth layer (46");
wherein the PV solar cell stack (15") of the third PV solar cell is disposed above the second layer (14") of the third PV solar cell;
wherein the third PV solar cell (206) further comprises an integrated, monolithic blocking diode stack (17") disposed above the second layer (14") of the third PV solar cell (206); and
wherein the integrated, monolithic blocking diode stack (17") comprises:
the third layer (16") of the third PV solar cell (206) disposed above the second layer (14") of the third PV solar cell (206);
the fourth layer (42") of the third PV solar cell (206) disposed above the third layer (16") of the third PV solar cell (206);
the fifth layer (44") of the third PV solar cell (206) disposed above the fourth layer (42") of the third PV solar cell (206);
the sixth layer (46") of the third PV solar cell (206) disposed above the fifth layer (44") of the third PV solar cell (206);
the seventh layer (48") of the third PV solar cell (206) disposed above the sixth layer (46") of the third PV solar cell (206);
an eighth layer (80") of the third PV solar cell (206) comprising an n-doped second semiconductor material disposed above the seventh layer (48") of the third PV solar cell (206); and
a ninth layer (82") of the third PV solar cell (206) comprising an p-doped second semiconductor material disposed above a portion of the eighth layer (80") of the third PV solar cell (206);
a first trench (22") of the third PV solar cell (206) extending down into the second layer (14") of the third PV solar cell (206), wherein the first trench (22") of the third PV solar cell (206) is disposed in between the PV solar cell stack (15") of the third PV solar cell (206) and the blocking diode (10");
a first metal contact (18") of the third PV solar cell (206) disposed above a portion of a top surface of the seventh layer (48") of the third PV solar cell (206); and
a second metal contact (20") of the third PV solar cell (206) disposed above the second layer (14") of the third PV solar cell (206);
a third metal contact (84") of the third PV solar cell (206) disposed above, and completely across, the ninth layer (82") of the third PV solar cell (206);
a fourth metal contact (86) of the third PV solar cell (206) disposed above a portion of the eighth layer (80") of the third PV solar cell (206);
a second trench (88") of the third PV solar cell (206) extending down into the eighth layer (80") of the third PV solar cell (206), and disposed in between the ninth layer (82") of the third PV solar cell (206) and the fourth metal contact (86) of the third PV solar cell (206);
a third trench (90") of the third PV solar cell (206) extending down into the third layer (16") of the third PV solar cell (206), and disposed in between the integrated, monolithic blocking diode stack (17") and the second metal contact (20") of the third PV solar cell (206); and
wherein the PV assembly (200) further comprises:
a first electrical conductor (92) connecting a second metal contact (20") of the third PV solar cell (206) to a fourth metal contact (86) of the third PV solar cell (206);
a second electrical conductor (120) connecting a first layer (12) of the first PV solar cell (202) to a first metal contact (18') of the second PV solar cell (204);
a third electrical conductor (120') connecting a first layer (12') of the second PV solar cell (204) to a first metal contact (18") of the third PV solar cell (206);
a fourth electrical conductor (124) connecting a first metal contact (18) of the first PV solar cell (202) to a negative side of a load (4); and
a fifth electrical conductor (122) connecting a third metal contact (84) of the third PV solar cell (206) to a positive side of the load (4);
wherein the first PV solar cell (202) is disposed adjacent to the second PV solar cell (204); and
wherein the second PV solar cell (204) is disposed adjacent to the third PV solar cell (206).

14. The PV assembly (200) of claim 13, wherein the second metal contact (20") of the third PV solar cell (206) is disposed above the third layer (16") of the third PV solar cell (206).

15. The PV assembly (200) of claim 13 or 14, wherein the first semiconductor material comprises Ge, wherein the second semiconductor material preferably comprises GaAs, and/or wherein the third semiconductor material preferably comprises InGaP.
